# EUROPEAN PATENT APPLICATION

(11) **EP 1 703 324 A1**
(43) Date of publication of application: **20.09.2006**
(21) Application number: 06005534.0
(22) Date of filing: 17.03.2006
(51) Int. Cl.: G03F 7/033

(54) **Photosensitive composition and lithographic printing plate precursor**

(30) Priority: 18.03.2005 JP 2005079646
(71) Applicant: FUJI PHOTO FILM CO., LTD., Minami-Ashigara-shi, Kanagawa (JP)
(72) Inventor: Shibuya, Akinori, c/o Fuji Photo Film Co., Ltd, Haibara-gun Shizuoka (JP)
(74) Representative: HOFFMANN EITLE

(57) **Abstract**

A photosensitive composition comprising: a polymer obtained by polymerization of a monomer having a structure represented by the formula (I) as defined herein; a polymerizable compound having an unsaturated double bond; and a radical polymerization initiator selected from a hexaarylbiimidazole compound and a metallocene compound.

## Description

### FIELD OF THE INVENTION

The present invention relates to a photosensitive composition and a lithographic printing plate precursor, and more particularly to a photosensitive composition and a lithographic printing plate precursor suitable for conducting drawing with a laser beam and suitable for high definition AM screen printing of screen line number of 200 or more or FM screen printing.

### BACKGROUND OF THE INVENTION

Lithographic printing plate precursors conventionally comprise a photosensitive resin layer provided on a support having a hydrophilic surface. As for the plate-making method thereof, the lithographic printing plate precursor is ordinarily subjected to open frame exposure (mask exposure) via a lith film and then removal of the non-image area with a developer to obtain a desired printing plate. However, with the recent progress of digitized techniques, a computer-to-plate (CTP) technique of directly conducting exposure process on the surface of the lithographic printing plate precursor by scanning according to digitized image data with highly convergent light, for example, a laser beam, without using a lith film has been developed. Lithographic printing plate precursors adapted for the technique have also been developed.

As the lithographic printing plate precursors suitable for exposure with a laser beam, lithographic printing plate precursors having a polymerizable photosensitive layer are exemplified. Because the polymerizable photosensitive layer is easily enable to increase sensitivity by appropriately selecting a polymerization initiator or a polymerization initiation system (hereinafter also simply referred to as an "initiator" and an "initiation system", respectively) in comparison with other conventional photosensitive layers.

However, when an image is drawn on such a lithographic printing plate precursor with a laser beam, a region of insufficient polymerization is formed in the edge of image due to an inadequate exposure amount depending on an energy distribution profile of the laser beam. Thus, sharpness of the edge of image is impaired, resulting in decrease in resolution. Also, in the region of insufficient polymerization formed in the edge of image, defect of removal occurs depending on alkali concentration of a developer or condition of a developing brush in a development processing step to cause a large variation of halftone dot area in a printing plate formed.

Moreover, since such a lithographic printing plate precursor comprises a support having a roughened surface according to electrolytic treatment or brush treatment in order to ensure hydrophilicity, image quality and sharpness are additionally injured and reproducibility in the shadow area is severely degraded due to scattering of reflection light at the laser exposure.

On the other hand, requirements for the high definition AM screen printing or FM screen printing have recently increased in the field of CTP technique. Therefore, the resolution of lithographic printing plate becomes an important performance.

The FM (Frequency Modulation) screen comprises fine halftone dots of approximately 20 microns irregularly arranged irrespective of screen angle and line number and expresses density gradation by halftone dot density per unit area. The features of FM screen print are that interference moire and rosette pattern do not occur, that tone jump in a halftone area of approximately 50% is avoided, and that due to the small size of halftone dot, overlap of halftone dots decreases so that the color reproduced can be brilliantly seen.

In contrast to the FM screen, the AM (Amplitude Modulation) screen comprises fine halftone dots regularly arranged at a certain angle and expresses density gradation by halftone dot size per unit area. In Japan, a line number of the AM screen is ordinarily 175 lines per inch. On the other hand, printing using a screen line number of 200 or more is defined as the high definition AM screen printing.

The characteristics of high definition print include decreases in the moire and rosette pattern, improvement in texture of image and improvements in feeling of reality and reproducibility of detail.

However, lithographic printing plate precursors accompanying the degradation of reproducibility in the shadow area, for example, the lithographic printing plate precursors having the polymerizable photosensitive layer described above are difficult to use for the purpose of providing printing plates suitable for the FM screen printing or high definition AM screen printing, because they cannot reproduce extremely fine halftone dots.

In JP-A-2003-43703 (the term "JP-A" as used herein means an "unexamined published Japanese patent application"), a lithographic printing plate precursor comprising a support having provided thereon an intermediate layer containing a polymer compound including a constituent unit having a sulfonic acid group in its side chain and a polymerizable photosensitive layer in order is described. However, the lithographic printing plate precursor is still insufficient for a printing plate precursor suitable for the high definition AM screen printing or FM screen printing. Particularly, since unevenness of halftone dot with the FM screen is severe, it is difficult to use the FM screen.

The applicant has been found that a lithographic printing plate precursor suitable for the FM screen printing can be prepared by using a binder polymer having a specific structure. However, when the lithographic printing plate precursor is subjected to development processing with a fatigued developer in the state of being neutralized by carbon dioxide in the air (developer having a lowered pH compared with a developer ordinarily used), halftone dot reproducibility may decrease (fine halftone dots may spread) in some cases. Therefore, a lithographic printing plate precursor capable of being developed with a developer having a wide range of pH is desired.

### SUMMARY OF THE INVENTION

An object of the present invention is to provide a photosensitive composition and a photopolymerization type lithographic printing plate precursor, which is suitable for conducting drawing with a laser beam and suitable for high definition AM screen printing of screen line number of 200 or more or FM screen printing, and particularly, which is excellent in uniformity of halftone dot in the halftone area in case of using the FM screen.

As a result of intensive investigations, the inventors have found that the above-described object can be achieved by the constitution described below.

Specifically, the present invention includes the following items.

### (1) A photosensitive composition comprising

(i) a polymer obtained by polymerization of a monomer having a structure represented by the following formula (I): 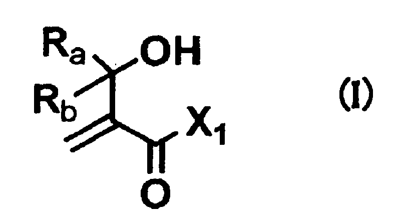 wherein X₁ represents -OR₁ or -N (R₂) (R₃), Rₐ and R_{b} each independently represents a hydrogen atom, a halogen atom, a cyano group or an organic group, and R₁, R₂ and R₃ each independently represents an alkyl group which may have a substituent, or Rₐ and R_{b} or X₁ and Rₐ or R_{b} may be connected with each other to form a cyclic structure;
(ii) a polymerizable compound having an unsaturated double bond; and
(iii) a radical polymerization initiator selected from a hexaarylbiimidazole compound and a metallocene compound.

### (2) A lithographic printing plate precursor comprising a photosensitive layer containing the photosensitive composition as described in (1) above.

According to the present invention, a photosensitive composition and a negative-working lithographic printing plate precursor can be provided, which is suitable for conducting drawing with a laser beam and suitable for high definition AM screen printing of screen line number of 200 or more or FM screen printing, particularly, which is excellent in uniformity of halftone dot in the halftone area in case of using the FM screen, and which has less pH dependency of a developer.

### DETAILED DESCRIPTION OF THE INVENTION

### [Lithographic Printing Plate Precursor]

With respect to the lithographic printing plate precursor (photosensitive lithographic printing plate) according to the invention, which comprises a support and a photosensitive layer containing the photosensitive composition containing a polymer obtained by polymerization of a monomer having a specific structure, the constitutions thereof will be described in order below.

### [Support]

First, a support for use in the lithographic printing plate precursor according to the invention is described below.

As for the support used in the invention, although any support having a hydrophilic surface can be employed, it is preferably a dimensionally stable plate-like material, for example, paper, paper laminated with plastic (for example, polyethylene, polypropylene or polystyrene), a plate of metal (for example, aluminum (including an alloy thereof), zinc or copper) or alloy (for example, alloy of aluminum with silicon, cupper, magnesium, chromium, zinc, lead, bismuth or nickel), a film of plastic (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal) and paper or a plastic film having laminated with or vapor-deposited thereon the above-described metal or alloy. Among these supports, the aluminum plate is particularly preferred, because it is extremely dimensional stable and relatively inexpensive. Also, a composite sheet comprising a polyethylene terephthalate film having bonded thereon an aluminum sheet described in JP-B-48-18327 (the term "JP-B" as used herein means an "examined published Japanese patent publication") is preferred. The thickness of the support is approximately from 0.05 to 1 mm.

In the case of using a support having a metal surface, particularly an aluminum surface, it is preferred that the support is subjected to surface treatment, for example, graining treatment, immersion treatment in an aqueous solution of sodium silicate, potassium fluorozirconate, a phosphate or the like, or anodizing treatment, described below.

### (Graining Treatment)

A method for the graining treatment includes mechanical graining, chemical etching and electrolytic graining, as described in JP-A-56-28893. Specifically, there may be employed an electrochemically graining method of electrochemically graining the surface in an electrolytic solution of hydrochloric acid or nitric acid and a mechanical graining method, for example, a wire brush graining method of scratching the aluminum surface with a metal wire, a ball graining method of graining the aluminum surface with grinding balls and an, abrasive and a brush graining method of graining the aluminum surface with a nylon brush and an abrasive. The graining methods may be employed individually or in combination thereof.

Of the methods, the electrochemical method of chemically graining the surface in an electrolytic solution of hydrochloric acid or nitric acid is an surface roughening method suitably used in the invention, and suitable current density is in a range of 100 to 400 C/dm². More specifically, it is preferred to conduct electrolysis in an electrolytic solution containing from 0. 1 to 50% by weight hydrochloric acid or nitric acid under the conditions from 20 to 100°C in temperature, from 1 second to 30 minutes in time and from 100 to 400 C/dm² in current density.

The aluminum support subjected to the graining treatment is then chemically etched with an acid or an alkali. The method of using an acid as an etching agent takes time for destroying fine structures and thus, it is disadvantageous to industrially apply the method to the invention. Such disadvantage can be overcome by using an alkali as the etching agent.

Examples of the alkali agent preferably used in the invention include sodium hydroxide, sodium carbonate, sodium aluminate, sodium metasilicate, sodium phosphate, potassium hydroxide and lithium hydroxide. Preferred ranges of concentration and temperature are form 1 to 50% by weight and from 20 to 100°C, respectively. The alkali etching is preferably performed so that a dissolution amount of aluminum is in a range of 5 to 20 g/m³.

After the etching procedure, the support is subjected to washing with an acid for removing stain (smut) remaining on the surface thereof. Examples of the acid for use in the acid-washing step include nitric acid, sulfuric acid, phosphoric acid, chromic acid, hydrofluoric acid and borohydrofluoric acid. In particular, as the method for removing smut after the electrochemical graining treatment, a method of bringing the aluminum support into contact with a 15 to 65% by weight aqueous solution of sulfuric acid having a temperature of 50 to 90°C as described in JP-A-53-12739 and a method of performing alkali etching as described in JP-B-48-28123 are preferably exemplified.

In the invention, surface roughness (Ra) of the aluminum support is preferably from 0.3 to 0.7 µm.

### (Anodizing Treatment)

The aluminum support thus-treated is then subjected to anodizing treatment. The anodizing treatment can be conducted in a manner conventionally used in the field of art.

Specifically, it is performed by applying a direct current or alternating current to the aluminum support in an aqueous solution or non-aqueous solution containing sulfuric acid, phosphoric acid, chromic acid, oxalic acid, sulfamic acid, benzenesulfonic acid or a combination of two or more thereof to form an anodic oxide layer on the surface of aluminum support.

The conditions of anodizing treatment cannot be determined in a general way, since they are widely varied depending on the electrolytic solution to be used. Ordinarily, however, a concentration of the electrolytic solution is in a range of 1 to 80%, a temperature of the electrolytic solution is in a range of 5 to 70°C, a current density is in a range of 0.5 to 60 ampere/dm², a voltage is in a range of 1 to 100 V, and a period of electrolysis is in a range of 10 to 100 seconds.

Of the anodizing treatments, a method of anodizing in a sulfuric acid solution with a high current density as described in British Patent 1,412,768 and a method of anodizing using phosphoric acid as an electrolytic bath as described in U.S. Patent 3,511,661 are preferably used.

In the invention, the amount of anodic oxide layer is preferably from 1 to 10 g/m², more preferably from 1.5 to 7 g/m², and still more preferably from 2 to 5 g/m².

In the invention, the aluminum support may further be subjected to sealing treatment after the graining treatment and anodizing treatment. The sealing treatment is performed by immersing the aluminum support in hot water or a hot aqueous solution containing an inorganic salt or an organic salt, or transporting the aluminum support in a water vapor bath. Moreover, the aluminum support for use in the invention may be subjected to surface treatment other than silicate treatment with an alkali metal silicate, for example, immersion treatment in an aqueous solution, for example, of potassium fluorozirconate or a phosphate.

According to the invention, to a support (in case of using an aluminum support, the aluminum support appropriately subjected to the above-described surface treatments is preferred), a polymerizable photosensitive layer comprising, for example, a photosensitive composition is applied and then a protective layer is applied to prepare a lithographic printing plate precursor. Before the application of the photopolymerizable photosensitive layer, if desired, an organic or inorganic subbing layer may be provided on the support, or the support may be subjected to a sol-gel treatment wherein a covalent bond of a functional group capable of generating an addition reaction upon a radical is formed as described in JP-A-7-159983.

A substance for forming the organic subbing layer includes, for example, a water-soluble resin, e.g., polyvinylphosphonic acid, a polymer or copolymer having a sulfonic acid group in the side chain thereof, polyacrylic acid, a water-soluble metal salt (e.g., zinc borate), a yellow dye and an amine salt.

More specifically, examples of the organic compound for use in the organic subbing layer include carboxymethyl cellulose, dextrin, gum arabic, a phosphonic acid having an amino group (for example, 2-aminoethylphosphonic acid), an organic phosphonic acid (for example, phenylphosphonic acid, naphthylphosphonic acid, alkylphosphonic acid, glycerophosphonic acid, methylenediphosphonic acid or ethylenediphosphonic acid, each of which may have a substituent), an organic phosphoric acid (for example, phenylphosphoric acid, naphthylphosphoric acid, alkylphosphoric acid or glycerophosphoric acid, each of which may have a substituent), an organic phosphinic acid (for example, phenylphosphinic acid, naphthylphosphinic acid, alkylphosphinic acid or glycerophosphinic acid, each of which may have a substituent), an amino acid (for example, glycine or β-alanine), and a hydrochloride of an amine containing a hydroxy group (for example, triethanolamine hydrochloride). The organic compounds may be used individually or as a mixture of two or more thereof.

The organic subbing layer can be provided in the following manner. Specifically, the organic compound as described above is dissolved in water, an organic solvent, for example, methanol, ethanol or methyl ethyl ketone, or a mixture thereof, the solution thus prepared is applied to the support and dried to form the organic subbing layer. Alternatively, the organic compound as described above is dissolved in water, an organic solvent, for example, methanol, ethanol or methyl ethyl ketone, or a mixture thereof, and the support is immersed in the solution thus prepared to adsorb the organic compound on the surface of support, then washed, for example, with water and dried to form the organic subbing layer. In the former method, the solution containing the organic compound in concentration of 0.005 to 10% by weight is coated by means of various methods. Any method, for example, bar coater coating, spin coating, spray coating or curtain coating can be employed. In the latter method, the concentration of the organic compound in the solution is preferably from 0.01 to 20% by weight, and more preferably from 0.05 to 5% by weight. The immersion temperature is preferably from 20 to 90°C, and more preferably from 25 to 50°C. The immersion time is preferably from 0. 1 second to 20 minutes, and more preferably from 2 seconds to one minute.

The solution of organic compound may be used by adjusting the pH thereof in a range of 1 to 12 with a basic substance, for example, ammonia, triethylamine or potassium hydroxide, or an acidic substance, for example, hydrochloric acid or phosphoric acid. Further, a yellow dye may be added to the solution in order to improve tone reproducibility of the photopolymerizable lithographic printing plate precursor.

The coverage of the organic subbing layer after drying is preferably from 2 to 200 mg/m², and more preferably from 5 to 100 mg/m². In the above-described range, sufficient printing durability is achieved.

A substance for use in the inorganic subbing layer includes an inorganic salt, for example, cobalt acetate, nickel acetate or potassium fluorotitanate. The method for the formation of the inorganic subbing layer is same as that of the organic subbing layer described above.

### [Photosensitive Layer]

The photosensitive layer for use in the lithographic printing plate precursor according to the invention contains components (i) to (iii) described below.
(i) A polymer obtained by polymerization of a monomer having a structure represented by the following formula (I): 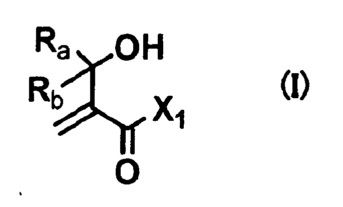 wherein X₁ represents -OR₁ or -N(R₂)(R₃), Rₐ and R_{b} each independently represents a hydrogen atom, a halogen atom, a cyano group or an organic group, and R₁, R₂ and R₃ each independently represents an alkyl group which may have a substituent, or Rₐ and R_{b} or X₁ and Rₐ or R_{b} may be connected with each other to form a cyclic structure.
(ii) A polymerizable compound having an unsaturated double bond.
(iii) A radical polymerization initiator selected from a hexaarylbiimidazole compound and a metallocene compound.

The components will be described in order below.

### (i) Binder polymer

Since the binder polymer not only functions as a film-forming agent of the photosensitive layer but also is required to be dissolved in an alkali developer, an organic polymer soluble or swellable in alkali water is used as the binder polymer.

The binder polymer used in the invention is a polymer obtained by polymerization of a monomer having a structure represented by formula (I) described above.

The monomer represented by formula (I) is described in more detail below. In formula (I), X₁ represents -OR₁ or -N(R₂) (R₃), Rₐ and R_{b} each independently represents a hydrogen atom, a halogen atom, a cyano group or an organic group. The organic group includes, for example, a hydrocarbon group which may have a substituent and/or an unsaturated bond, a substituted oxy group, a substituted thio group, a substituted amino group, a substituted carbonyl group or a carboxylato group. Alternatively, Rₐ and R_{b}, X₁ and Rₐ or X₁ and R_{b} may be combined with each other to form a cyclic structure. R₁, R₂ and R₃ each independently represents an alkyl group which may have a substituent.

Each of the substituents in R₁, R₂, R₃, Rₐ and R_{b} in formula (I) is described below.

The hydrocarbon group which may have a substituent and/or an unsaturated bond includes an alkyl group, a substituted alkyl group, an aryl group, a substituted aryl group, an alkenyl group, a substituted alkenyl group an alkynyl group and a substituted alkynyl group.

The alkyl group includes a straight chain, branched or cyclic alkyl group having from 1 to 20 carbon atoms. Specific examples thereof include methyl, ethyl, propyl, butyl, pentyl, hexyl, heptyl, octyl, nonyl, decyl, undecyl, dodecyl, tridecyl, hexadecyl, octadecyl, eicosyl, isopropyl, isobutyl, sec-butyl, tert-butyl, isopentyl, neopentyl, 1-methylbutyl, isohexyl, 2-ethylhexyl, 2-methylhexyl, cyclohexyl, cyclopentyl and 2-norbornyl groups. Of the alkyl groups, a straight chain alkyl group having from 1 to 12 carbon atoms, a branched alkyl group having from 3 to 12 carbon atoms and a cyclic alkyl group having from 5 to 10 carbon atoms are preferred.

The substituted alkyl group is composed of a substituent bonding to an alkylene group. The substituent includes a monovalent non-metallic atomic group exclusive of a hydrogen atom. Preferred examples of the substituent for the alkyl group include a halogen atom (e.g., fluorine, bromine, chlorine or iodine), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, N'-arylureido group, an N',N'-diarylureido group, an N'-alkyl-N'-arylureido group, an N-alkylureido group, N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxy group and a conjugate base group thereof (hereinafter, referred to as a carboxylato group), an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugate base group thereof (hereinafter, referred to as a sulfonato group), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugate base group thereof, an N-alkylsulfonylsulfamoyl group (-SO₂NHSO₂(alkyl)) and a conjugate base group thereof, an N-arylsulfonylsulfamoyl group (-SO₂NHSO₂(aryl)) and a conjugate base group thereof, an N-alkylsulfonylcarbamoyl group (-CONHSO₂(alkyl)) and a conjugate base group thereof, an N-arylsulfonylcarbamoyl group (-CONHSO₂ (aryl)) and a conjugate base group thereof, an alkoxysilyl group (-Si(O-alkyl)₃), an aryloxysilyl group (-Si(O-aryl)₃), a hydroxysilyl group (-Si (OH)₃) and a conjugate base group thereof, a phosphono group (-PO₃H₂) and a conjugate base group thereof (hereinafter, referred to as a phosphonato group), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof (hereinafter, referred to as an alkylphosphonato group), a monoarylphosphono group (-PO₃H (aryl)) and a conjugate base group thereof (hereinafter, referred to as an arylphosphonato group), a phosphonoxy group (-OP0₃H₂) and a conjugate base group thereof (hereinafter, referred to as a phosphonatoxy group), a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof (hereinafter, referred to as an alkylphosphonatoxy group), a monoarylphosphonoxy group (-OPO₃H (aryl)) and a conjugate base group thereof (hereinafter, referred to as an arylphosphonatoxy group), a cyano group, a nitro group, an aryl group, an alkenyl group and an alkynyl group.

Specific examples of the alkyl group in the substituents include those described above. Specific examples of the aryl group in the substituents include phenyl, biphenyl, naphthyl, tolyl, xylyl, mesityl, cumenyl, fluorophenyl, chlorophenyl, bromophenyl, chloromethylphenyl, hydroxyphenyl, methoxyphenyl, ethoxyphenyl, phenoxypnenyl, acetoxyphenyl, benzoyloxyphenyl, methylthiophenyl, phenylthiophenyl, methylaminophenyl, dimethylaminophenyl, acetylaminophenyl, carboxyphenyl, methoxycarbonylphenyl, ethoxycarbonylphenyl, phenoxycarbonylphenyl, N-phenylcarbamoylphenyl, phenyl, nitrophenyl, cyanophenyl, sulfophenyl, sufonatophenyl, phosphonophenyl and phosphonatophenyl groups. Specific examples of the alkenyl group include vinyl, 1-propenyl, 1-butenyl, cinnamyl and 2-chloro-1-ethenyl groups. Specific examples of the alkenyl group include ethynyl, 1-propynyl, 1-butynyl, trimethylsilylethynyl and phenylethynyl groups.

In the acyl group (R⁴CO-) described above, R⁴ represents a hydrogen atom, or the above-described alkyl group, aryl group, alkenyl group or alkynyl group.

In the substituted alkyl group, the alkylene group includes a divalent organic residue obtained by eliminating any one of hydrogen atoms on the alkyl group having from 1 to 20 carbon atoms described above, and preferably a straight chain alkylene group having from 1 to 12 carbon atoms, a branched alkylene group having from 3 to 12 carbon atoms and a cyclic alkylene group having from 5 to 10 carbon atoms. Specific preferred examples of the substituted alkyl group include chloromethyl, bromomethyl, 2-chloroethyl, trifluoromethyl, methoxymethyl, methoxyethoxyethyl, allyloxymethyl, phenoxymethyl, methyltiomethyl, tolylthiomethyl, ethylaminoethyl, diethylaminopropyl, morpholinopropyl, acetyloxymethyl, benzoyloxymethyl, N-cyclohexylcarbamoyloxyethyl, N-phenylcarbamoyloxyethyl, acetylaminoethyl, N-methylbenzoylaminopropyl, 2-oxoethyl, 2-oxopropyl, carboxypropyl, methoxycarbonylethyl, methoxycarbonylmethyl, methoxycarbonylbutyl, ethoxycarbonylmethyl, butoxycarbonylmethyl, allyloxycarbonylmethyl, benzyloxycarbonylmethyl, methoxycarbonylphenylmethyl, trichloromethylcarbonylmethyl, allyloxycarbonylbutyl, chlorophenoxycarbonylmethyl, carbamoylmethyl, N-methylcarbamoylethyl, N,N-dipropylcarbamoylmethyl, N-(methoxyphenyl)carbamoylethyl, N-methyl-N-(sulfophenyl)carbamoylmethyl, sulfopropyl, sulfobutyl, sulfonatobutyl, sulfamoylbutyl, N-ethylsulfamoylmethyl, N,N-dipropylsulfamoylpropyl, N-tolylsulfamoylpropyl, N-methyl-N-(phosphonophenyl)sulfamoyloctyl, phosphonobutyl, phosphonatohexyl, diethylphosphonobutyl, diphenylphosphonopropyl, methylphosphonobutyl, methylphosphonatobutyl, tolylphosphonohexyl, tolylphosphonatohexyl, phosphonoxypropyl, phosphonatoxybutyl, benzyl, phenethyl, α-methylbenzyl, 1-methyl-1-phenylethyl, p-methylbenzyl, cinnamyl, allyl, 1-propenylmethyl, 2-butenyl, 2-methylallyl, 2-methylpropenylmethyl, 2-propynyl, 2-butynyl and 3-butynyl groups, and groups shown below.

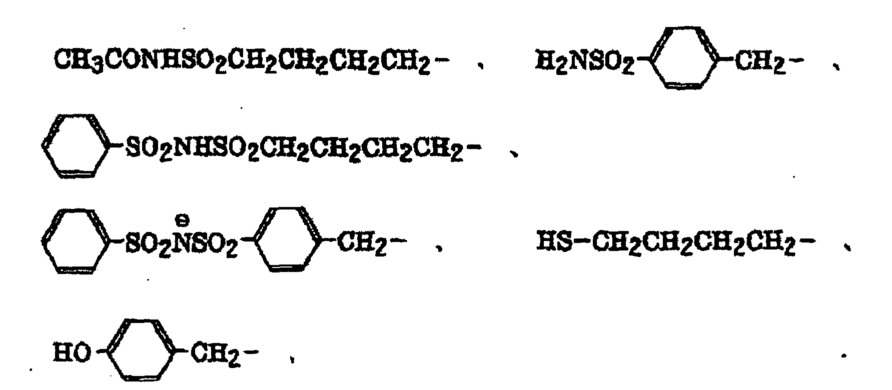

The aryl group includes a condensed ring of one to three benzene rings and a condensed ring of a benzene ring and a 5-membered unsaturated ring. Specific examples of the aryl group include phenyl, naphthyl, anthryl, phenanthryl, indenyl, acenaphthenyl and fluorenyl groups. Among them, a phenyl group and a naphthyl group are preferred.

The substituted aryl group is a group formed by bonding a substituent to an aryl group and includes groups having a monovalent non-metallic atomic group exclusive of a hydrogen atom, as a substituent, on the ring-forming carbon atoms of the above-described aryl group. Examples of the substituent include the above-described alkyl and substituted alkyl group and the substituents for the substituted alkyl group. Specific preferred examples of the substituted aryl group include biphenyl, tolyl, xylyl, mesityl, cumenyl, chlorophenyl, bromophenyl, fluorophenyl, chloromethylphenyl, trifluoromethylphenyl, hydroxyphenyl, methoxyphenyl, methoxyethoxyphenyl, allyloxyphenyl, phenoxyphenyl, methylthiophenyl, tolylthiophenyl, phenylthiophenyl, ethylaminophenyl, diethylaminophenyl, morpholinophenyl, acetyloxyphenyl, benzoyloxyphenyl, N-cyclohexylcarbamoyloxyphenyl, N-phenylcarbamoyloxyphenyl, acetylaminophenyl, N-methylbenzoylaminophenyl, carboxyphenyl, methoxycarbonylphenyl, allyloxycarbonylphenyl, chlorophenoxycarbonylphenyl, carbamoylphenyl, N-methylcarbamoylphenyl, N,N-dipropylcarbamoylphenyl, N-(methoxyphenyl)carbamoylphenyl, N-methyl-N-(sulfophenyl)carbamoylphenyl, sulfophenyl, sulfonatophenyl, sulfamoylphenyl, N-ethylsulfamoylphenyl, N,N-dipropylsulfamoylphenyl, N-tolylsulfamoylphenyl, N-methyl-N-(phosphonophenyl)sulfamoylphenyl, phosphonophenyl, phosphonatophenyl, diethylphosphonophenyl, diphenylphosphonophenyl, methylphosphonophenyl, methylphosphonatophenyl, tolylphosphonophenyl, tolylphosphonatophenyl, allylphenyl, 1-propenylmethylphenyl, 2-butenylphenyl, 2-methylallylphenyl, 2-methylpropenylphenyl, 2-propynylphenyl, 2-butynylphenyl and 3-butynylphenyl groups.

The alkenyl group includes that described above. The substituted alkenyl group is a group formed by replacing a hydrogen atom of the alkenyl group with a substituent. Examples of the substituent include the substituents for the substituted alkyl group described above, and the alkenyl group is that described above. Preferred examples of the substituted alkenyl group include the following groups:

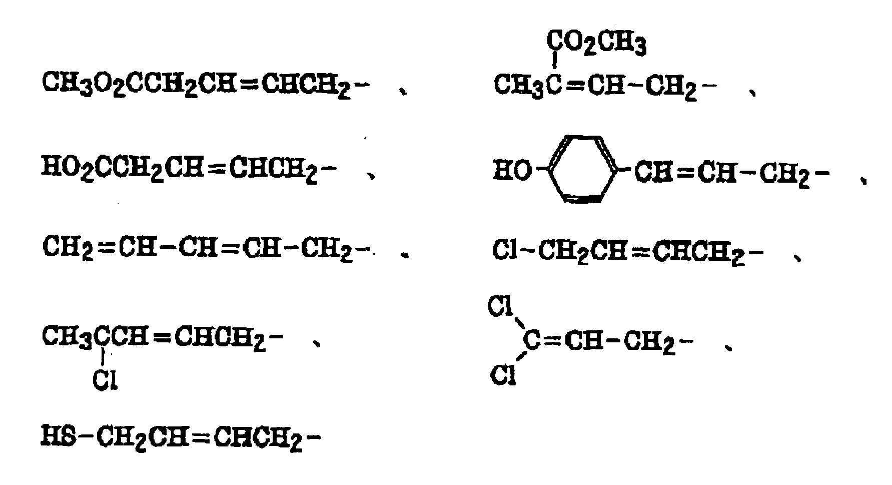

The alkynyl group includes that described above. The substituted alkynyl group is a group formed by replacing a hydrogen atom of the alkynyl group with a substituent. Examples of the substituent include the substituents for the substituted alkyl group described above, and the alkynyl group is that described above.

In the substituted oxy group (R₅O-) described above, R₅ represents a monovalent non-metallic atomic group excusive of a hydrogen atom. Preferred examples of the substituted oxy group include an alkoxy group, an aryloxy group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, a phosphonoxy group and a phosphonatoxy group. The alkyl group and aryl group in the above-described substituted oxy group include those described for the alkyl group, substituted alkyl group, aryl group and substituted aryl group above. In an acyl group (R₆CO-) in the acyloxy group described above, R₆ represents the alkyl group, substituted alkyl group, aryl group and substituted aryl group described above. Of the substituted oxy groups, an alkoxy group, an aryloxy group, an acyloxy group and an arylsulfoxy group are more preferred. Specific preferred examples of the substituted oxy group include methoxy, ethoxy, propyloxy, isopropyloxy, butyloxy, pentyloxy, hexyloxy, dodecyloxy, benzyloxy, allyloxy, phenethyloxy, carboxyethyloxy, methoxycarbonylethyloxy, ethoxycarbonylethyloxy, methoxyethoxy, phenoxyethoxy, methoxyethoxyethoxy, ethoxyethoxyethoxy, morpholinoethoxy, morpholinopropyloxy, allyloxyethoxyethoxy, phenoxy, tolyloxy, xylyloxy, mesityloxy, cumenyloxy, methoxyphenyloxy, ethoxyphenyloxy, chlorophenyloxy, bromophenyloxy, acetyloxy, benzoyloxy, naphthyloxy, phenylsulfonyloxy, phosphonoxy and phosphonatoxy groups.

In the substituted thio group (R₇S-) described above, R₇ represents a monovalent non-metallic atomic group excusive of a hydrogen atom. Preferred examples of the substituted thio group include an alkylthio group, an arylthio group, an alkyldithio group, an aryldithio group and an acylthio group. The alkyl group and aryl group in the above-described substituted thio group include those described for the alkyl group, substituted alkyl group, aryl group and substituted aryl group above. In an acyl group (R₆CO-) in the acylthio group described above, R₆ has the same meaning as described above. Of the substituted thio groups, an alkylthio group and an arylthio group are more preferred. Specific preferred examples of the substituted thio group include methylthio, ethylthio, phenylthio, ethoxyethylthio, carboxyethylthio and methoxycarbonylthio groups.

In the substituted amino group (R₈NH- or (R₉) (R₁₀) N-) described above, R₈, R₉ and R₁₀ each represents a monovalent non-metallic atomic group excusive of a hydrogen atom. Preferred examples of the substituted amino group include an N-alkylamino group, an N,N-dialkylamino group, an N-arylamino group, an N,N-diarylamino group, an N-alkyl-N-arylamino group, an acylamino group, an N-alkylacylamino group, an N-arylacylamino group, a ureido group, an N'-alkylureido group, an N',N'-dialkylureido group, an N'-arylureido group, an N' ,N' -diarylureido group, an N' -alkyl-N' -arylureido group, an N-alkylureido group, an N-arylureido group, an N' -alkyl-N-alkylureido group, an N' -alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group and an N-aryl-N aryloxycarbonylamino group. The alkyl group and aryl group in the above-described substituted amino group include those described for the alkyl group, substituted alkyl group, aryl group and substituted aryl group above. In an acyl group (R₆CO-) in the acylamino group, N-alkylacylamino group or N-arylacylamino group described above, R₆ has the same meaning as described above. Of the substituted amino groups, an N-alkylamino group, an N,N-dialkylamino group, an N-arylamino group and an acylamino group are more preferred. Specific preferred examples of the substituted amino group include methylamino, ethylamino, diethylamino, morpholino, piperidino, pyrrolidino, phenylamino, benzoylamino and acetylamino groups.

In the substituted carbonyl group (R₁₁-CO-) described above, R₁₁ represents a hydrogen atom or a monovalent non-metallic atomic group. Preferred examples of the substituted carbonyl group include a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group and an N-alkyl-N-arylcarbamoyl group. The alkyl group and aryl group in the above-described substituted carbonyl group include those described for the alkyl group, substituted alkyl group, aryl group and substituted aryl group above. Of the substituted carbonyl groups, a formyl group, an acyl group, a carboxy group, an alkoxycarbonyl group, an aryloxycarbonyl group, a carbamoyl group, an N-alkylcarbamoyl group, an N,N-dialkylcarbamoyl group and an N-arylcarbamoyl group are more preferred, and a formyl group, an acyl group, an alkoxycarbonyl group and an aryloxycarbonyl group are still more preferred. Specific preferred examples of the substituted carbonyl group include formyl, acetyl, benzoyl, carboxy, methoxycarbonyl, allyloxycarbonyl, N-methylcarbamoyl, N-phenylcarbamoyl, N,N-diethylcarbamoyl and morpholinocarbonyl groups.

The calboxylato group (-CO₂⁻) described above means a conjugate base anion group of a carboxy group (-CO₂H). Ordinarily, it is preferred to use together with a counter cation. Examples of the counter cation include those conventionally known, for example, various oniums (e.g., ammonium, sulfonium, phosphoniumiodoniumorazinium) and metal ions (e.g., Na⁺, K⁺, Ca²⁺ or Zn²⁺).

Preferred substituent for R₁, R₂ or R₃ includes a hydrocarbon group which may have a substituent and/or an unsaturated bond. Preferred examples thereof include an alkyl group having from 1 to 18 carbon atoms, an alkyl group including an alicyclic structure having from 5 to 20 carbon atoms and a group including an aromatic ring having from 6 to 20 carbon atoms, and particularly preferred examples thereof include an alkyl group including an alicyclic structure having from 5 to 10 carbon atoms.

Specific examples of the structure unit of a polymer obtained by polymerization of a monomer having a structure represented by formula (I) are set forth below, but the invention should not be construed as being limited thereto.

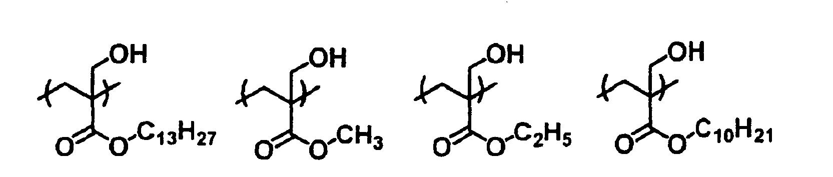

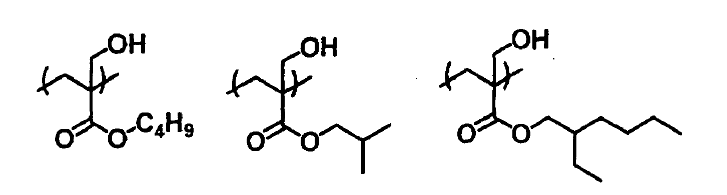

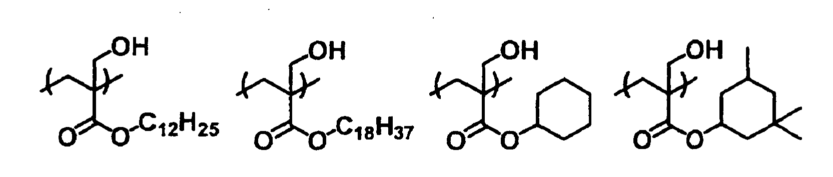

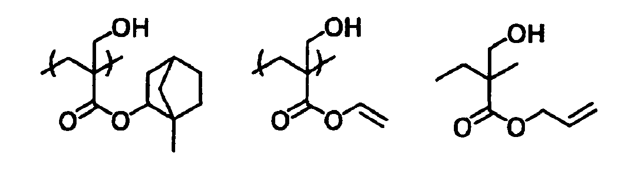

The polymer obtained by polymerization of a monomer having the specific structure used in the invention preferably further includes a structure unit represented by formula (II) or (III) shown below.

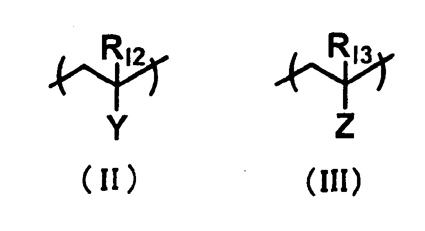

In formulae, R₁₂ and R₁₃ each independently represents a hydrogen atom or an alkyl group having from 1 to 6 carbon atoms, Y represents a functional group selected from -COOH, -CO-W₁-L₁-COOH or -SO3H, W₁ represents an oxygen atom, a sulfur atom or -NH-, L₁ represents a divalent organic group, Z represents -CO-O-CH₂-CH=CH₂ or -CO-W₂-L₂-O-CO-CR₁₄=CH₂, W₂ represents an oxygen atom, a sulfur atom or -NH-, L₂ represents a divalent organic group, and R₁₄ represents a hydrogen atom or an alkyl group having from 1 to 6 carbon atoms.

Specific examples of the structure unit represented by formula (II) or (III) are set forth below, but the invention should not be construed as being limited thereto.

Specific examples of the structure unit represented by formula (II) are set forth below.

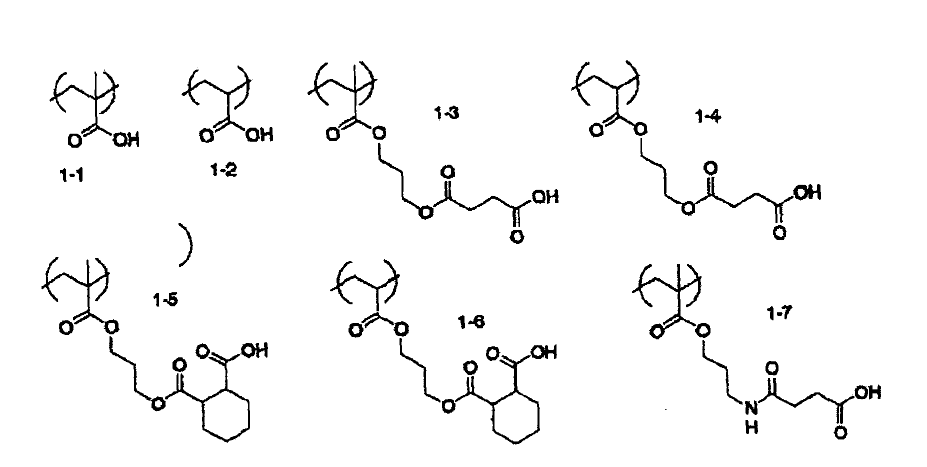

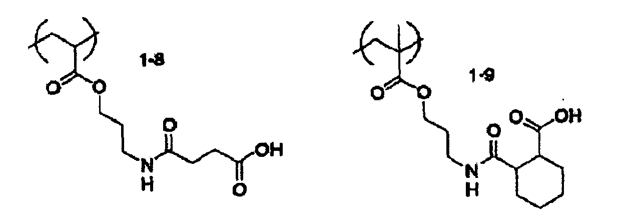

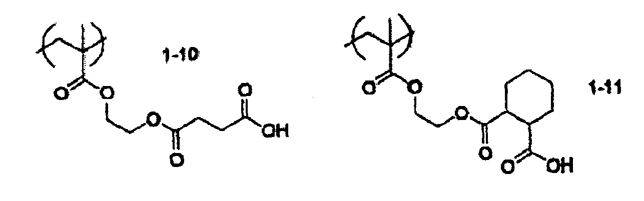

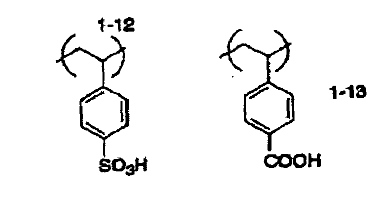

Specific examples of the structure unit represented by formula (III) are set forth below.

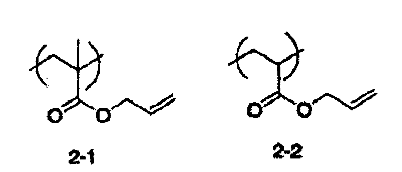

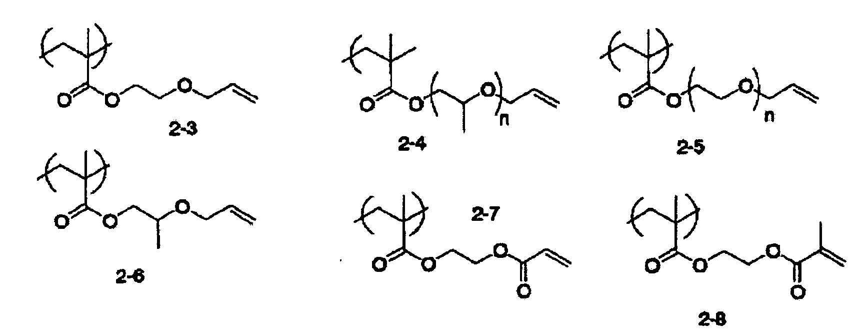

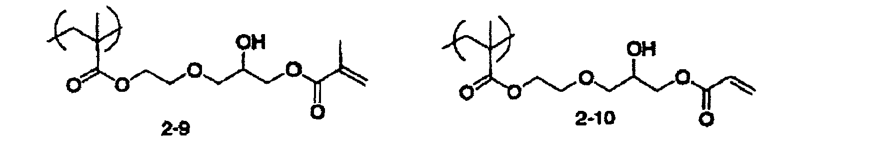

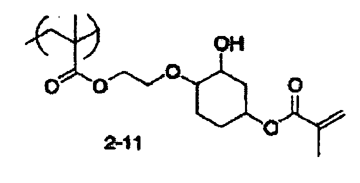

In order to ensure developing property of the photosensitive layer, it is preferred that the binder polymer used in the invention has adequate molecular weight and acid value. The binder polymer having a weight average molecular weight from 5, 000 to 300, 000, preferably from 10, 000 to 200, 000, and an acid value preferably from 0.4 to 3.0 meq/g, more preferably from 0. 6 to 2.0 meq/g is especially preferable. The term "acid value" of the binder polymer as used herein mans a ratio of an acid contained per g of the polymer in terms of a chemical equivalent number.

Any combination of the structure units represented by formulae (I), (II) and (III) may be used as long as the above-described molecular weight, acid value and amount of double bond included are satisfied. The ratio of the structure units represented by formulae (I) , (II) and (III) is preferably in a rage wherein (I) is from 1 to 70 % by weight, (II) is from 0.5 to 98% by weight and (III) is from 0.5 to 98% by weight, more preferably in a rage wherein (I) is from 1 to 50 % by weight, (II) is from 0.5 to 50% by weight and (III) is from 0.5 to 90% by weight, and still more preferably in a rage wherein (I) is from 1 to 30 % by weight, (II) is from 0.5 to 30% by weight and (III) is from 0.5 to 90% by weight, in terms of weight ratio.

Further, as long as the above-described molecular weight, acid value and amount of double bond included are satisfied, a structure unit other than the structure units represented by formulae (I), (II) and (III) may also be added as a copolymerization component.

Examples of the copolymerization component preferably used in the polymer according to the invention include (substituted) acrylates, for example, methyl acrylate, ethyl acrylate, propyl acrylate, butyl acrylate, amyl acrylate, hexyl acrylate, cyclohexyl acrylate, octyl acrylate, phenyl acrylate, benzyl acrylate, 2-chloroethyl acrylate, 4-hydroxybutyl acrylate, glycidyl acrylate or N-dimethylaminoethyl acrylate, (substituted) methacrylates, for example, methyl methacrylate, ethyl methacrylate, propyl methacrylate, butyl methacrylate, amyl methacrylate, hexyl methacrylate, cyclohexyl methacrylate, octyl methacrylate, phenyl methacrylate, benzyl methacrylate, 2-chloroethyl methacrylate, 4-hydroxybutyl methacrylate, glycidyl methacrylate or N-dimethylaminoethyl methacrylate, and acrylamides and methacrylamides, for example, acrylamide, methacrylamide, N-methylolacrylamide, N-methylolmethacrylamide, N-ethylacrylamide, N-ethylmethacrylamide, N-hexylacrylamide, N-hexylmethacrylamide, N-cyclohexylacrylamide, N-cyclohexylmethacrylamide, N-hydroxyethylacrylamide, N-hydroxyethylmethacrylamide, N-phenylacrylamide, N-phenylmethacrylamide, N-benzylacrylamide, N-benzylmethacrylamide, N-nitrophenylacrylamide, N-nitrophenylmethacrylamide, N-ethyl-N-phenylacrylamide or N-ethyl-N-phenylmethacrylamide.

Specific examples (P-1 to P-20) of the specific polymer according to the invention are set forth below, but the invention should not be construed as being limited thereto.

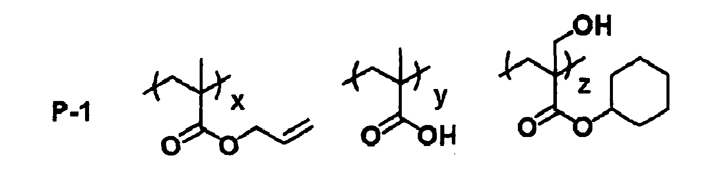

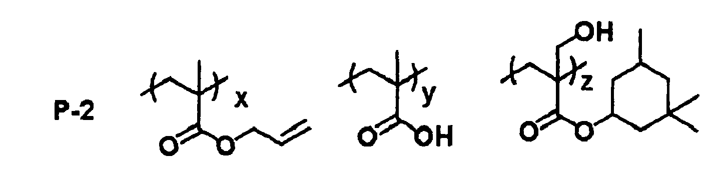

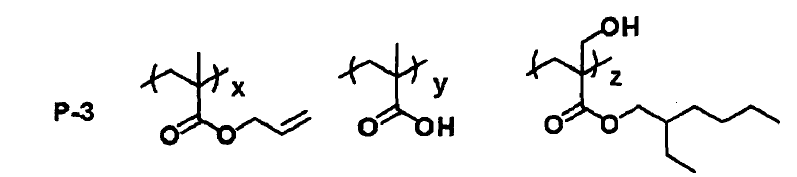

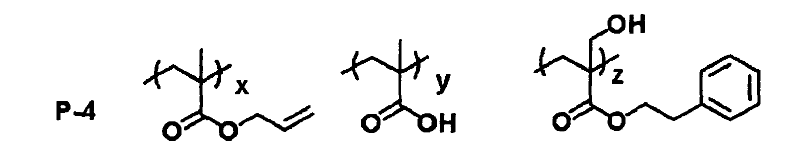

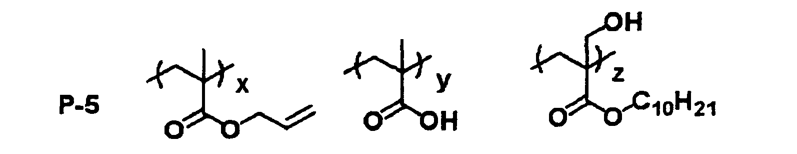

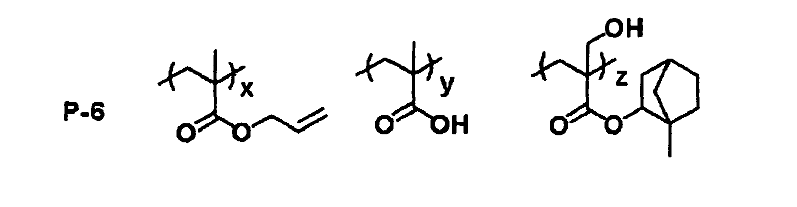

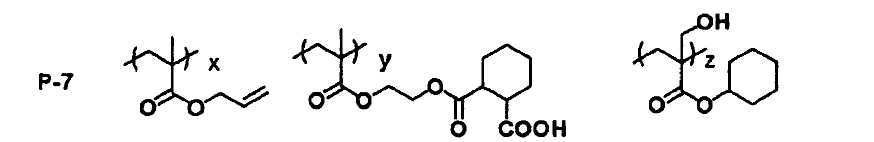

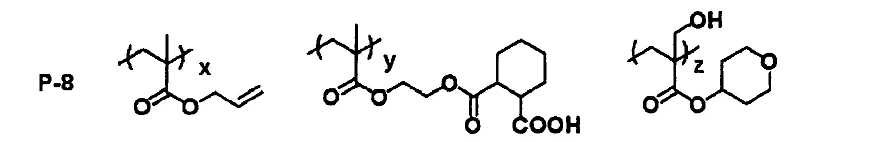

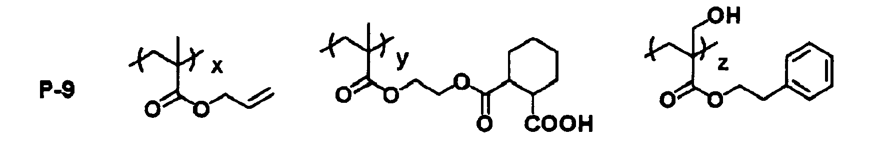

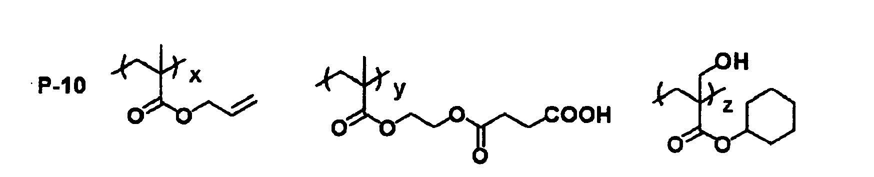

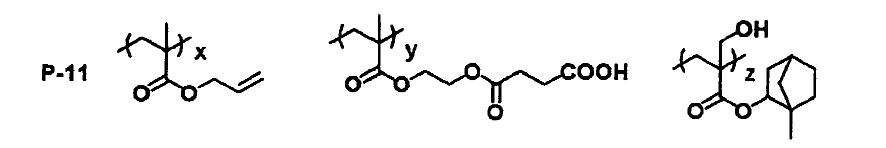

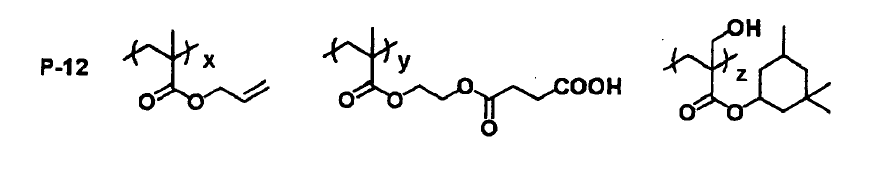

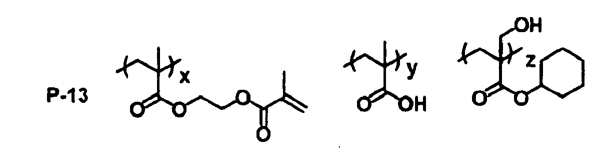

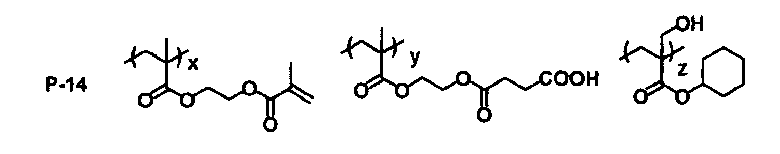

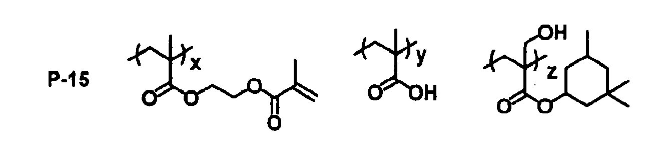

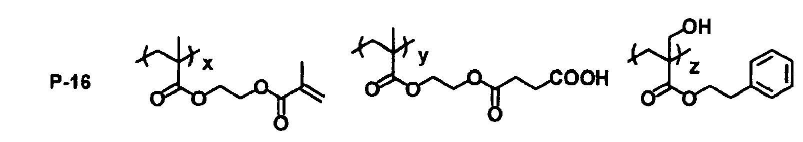

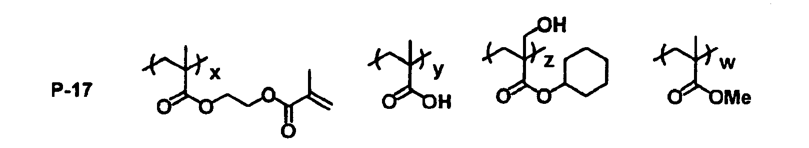

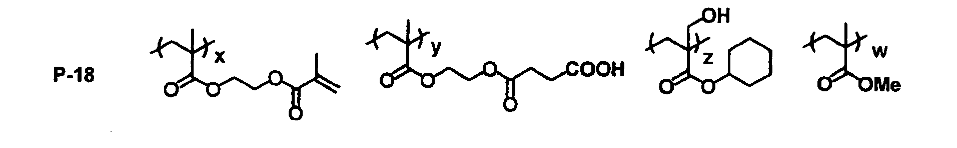

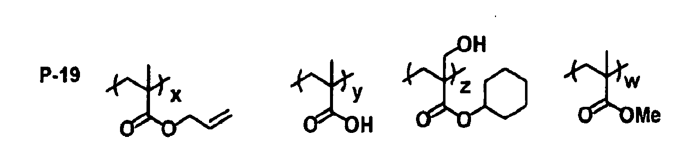

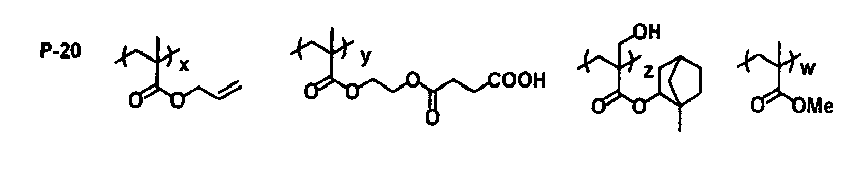

The binder polymer can be incorporated in an appropriate amount into the photosensitive layer. The amount is preferably from 10 to 90% by weight, and more preferably from 30 to 80% by weight, based on the photosensitive layer.

In the invention, a binder polymer other than the binder polymer described above can be used as a mixture.

As the other binder polymer, various kinds of polymers are exemplified. When the lithographic printing plate precursor is desired to be developed with water, a water-soluble organic polymer is used. Examples of such an organic polymer include addition polymers having a carboxylic acid group in the side chain thereof, for example, polymers described in JP-A-59-44615, JP-B-54-34327, JP-B-58-12577, JP-B-54-25957, JP-A-54-92723, JP-A-59-53836 and JP-A-59-71048, more specifically, methacrylic acid copolymers, acrylic acid copolymers, itaconic acid copolymers, crotonic acid copolymers, maleic acid copolymers and partially esterified maleic acid copolymers, acidic cellulose derivatives having a carboxylic acid group in the side chain thereof, polymers obtained by adding a cyclic acid anhydride to an addition polymer having a hydroxy group, polyvinyl pyrrolidone, polyethylene oxide, and alcohol-soluble polyamides and polyethers of 2,2-bis-(4-hydroxyphenyl)propane with epichlorohydrin capable of increasing strength of a cured film.

Further, polyurethane resins as described in JP-B-7-120040, JP-B-7-120041, JP-B-7-120042, JP-B-8-12424, JP-A-63-287944, JP-A-63-287947, JP-A-1-271741 and JP-A-11-352691 are also useful in the invention.

### (ii) Polymerizable compound having an unsaturated double bond

The polymerizable compound having an unsaturated double bond included in the photosensitive layer used in the invention can be appropriately selected from compounds having at least one, preferably two or more ethylenically unsaturated double bond groups.

The compound has a chemical form, for example, a monomer, a prepolymer (i.e., a dimmer, trimer or oligomer), a copolymer thereof or a mixture thereof.

Examples of the monomer and copolymer include esters between an unsaturated carboxylic acid (for example, acrylic acid, methacrylic acid, itaconic acid, crotonic acid, isocrotonic acid or maleic acid) and an aliphatic polyhydric alcohol compound and amides between an unsaturated carboxylic acid and an aliphatic polyvalent amine compound.

Specific examples of the monomer of the ester between an aliphatic polyhydric alcohol compound and an unsaturated carboxylic acid include:
acrylates, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate or polyester acrylate oligomer;
methacrylates, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmetha ne or bis-[p-(methacryloxyethoxy)phenyl]dimethylmethane;
itaconates, for example, ethylene glydcol diitaconate, propylene glycol diitaconate, 1,3-butanediol diitaconate, 1,4-butanediol diitaconate, tetramethylene glycol diitaconate, pentaerythritol diitaconate or sorbitol tetraitaconate;
crotonatates, for example, ethylene glycol dicrotonate, tetramethylene glycol dicrotonate, pentaerythritol dicrotonate or sorbitol tetradicrotonate;
isocrotonates, for example, ethylene glycol diisocrotonate, pentaerythritol diisocrotonate or sorbitol tetraisocrotonate;
and maleates, for example, ethylene glycol dimaleate, triethylene glycol dimaleate, pentaerythritol dimaleate or sorbitol tetramaleate.

Further, mixtures of the ester monomers are exemplified.

Also, specific examples of the monomer of the amide between an aliphatic polyvalent amine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.

Also, urethane acrylates as described in JP-A-51-37193, polyester acrylates as described in JP-A-48-64183, JP-B-49-43191 and JP-B-52-30490, and polyfunctional acrylates or methacrylates, for example, epoxyacrylates obtained by reacting an epoxy resin with (meth) acrylic acid are exemplified. Further, photo-curable monomers and oligomers described in Nippon Secchaku Kyokaishi, Vol. 20, No. 7, pages 300 to 308 (1984) can be used.

Specifically, NK OLIGO U-4HA, NK OLIGO U-4H, NK OLIGO U-6HA, NK OLIGO U-108A, NK OLIGO U-1084A, NK OLIGO U-200AX, NK OLIGO U-122A, NK OLIGO U-340A, NK OLIGO UA-324A and NK OLIGO UA-100 (all of which are produced by Shin-Nakamura Chemical Co. , Ltd.); UA-306H, AI-600, UA-101T, UA-101I, UA-306T and UA-306I (all of which are produced by Kyoeisha Chemical Co. , Ltd.) ; and ART RESIN UN-9200A, ART RESIN UN-3320HA, ART RESIN UN-3320HB, ART RESIN UN-3320HC, ART RESIN SH-380G, ART RESIN SH-500 and ART RESIN SH-9832 (all of which are produced by Negami Chemical Industrial Co., Ltd.) are exemplified.

The amount of the polymerizable compound having an unsaturated double bond used is preferably from 5 to 90% by weight, more preferably from 10 to 80% by weight, based on the total components of the photosensitive layer.

A ratio of (ii) the polymerizable compound having an unsaturated double bond to (i) the polymer obtained by polymerization of a monomer having a structure represented by formula (I) used in the invention is preferably 1.5 or below, more preferably from 0. 1 to 1.5, still more preferably from 0. 1 to 1.0, and even still more preferably from 0.1 to 0.8, in terms of weight ratio of (ii)/(i).

### (iii) Radical polymerization initiator

Now, the radical polymerization initiator contained in the photosensitive layer according to the invention will be described below. The polymerization initiator contained in the photosensitive layer according to the invention is a radical polymerization initiator selected from a hexaarylbiimidazole compound and a metallocene compound. Specific examples of the both polymerization initiators are described below.

### (Hexaarylbiimidazole compound)

The hexaarylbiimidazole compound is excellent in stability and can generate a radical in high sensitivity. Specifically, for example,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazo le,
2,2'-bis(o-chlorophenyl)-4,4',5,5'-tetra(m-methoxyphenyl)bi imidazole,
2,2'-bis(o,o'-dichlorophenyl)-4,4',5,5'-tetraphenylbiimidaz ole,
2,2'-bis(o-nitrophenyl)-4,4',5,5'-tetraphenylbiimidazole,
2,2'-bis(o-methylphenyl)-4,4',5,5'-tetraphenylbiimidazole and
2,2'-bis(o-trifluoromethylphenyl)-4,4',5,5'-tetraphenylbiim idazole are enumerated.

### (Metallocene compound)

Preferable metallocene compounds include ferrocene and iron-arene complexes described in JP-A-1-152109 and JP-A-1-304453 and titanocene compounds described in JP-A-59-152396 and JP-A-61-151197. The titanocene compound is preferably exemplified and specific examples thereof include dicyclopentadienyl-Ti-dichloride, dicyclopentadienyl-Ti-bisphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-triafluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1 -yl, dimethylcyclopentadienyl-Ti-bis-2,3,5,6-tetrafluorophen-1-y 1, dimethylcyclopentadienyl-Ti-bis-2,4-difluorophen-1-yl, bis(cyclopentadienyl)-bis(2,6-difluoro-3-(pyl-1-yl)phenyl) titanium.

Among the polymerization initiators, the hexaarylbiimidazole compounds are particularly preferable. From the standpoint of compatibility with the binder polymer obtained by polymerization of a monomer having the specific structure used in the invention, hexaarylbiimidazole compounds having chlorine atoms at the o-position of aromatic rings of 2 and 2' positions thereof are preferable.

The polymerization initiator may be subjected to various chemical modifications in order to improve performances of the photosensitive layer. Examples of the modification method which can be utilized include binding with a sensitizing dye, an polymerizable compound having an unsaturated double bond or other initiator part, introduction of a hydrophilic site, introduction of a substituent for improving compatibility or inhibiting crystallization, introduction of a substituent for improving adhesion, and formation of a polymer.

A method of using the polymerization initiator can also be appropriately and freely selected according to the designed performances of the lithographic printing plate precursor. For example, by using two or more kinds of the polymerization initiators, the compatibility in the photosensitive layer can be increased. In view of photosensitivity, use of the polymerization initiator in a larger amount is usually more advantageous. Sufficiently high sensitivity can be obtained by using the polymerization initiator in an amount preferably from 0.5 to 80 parts by weight, more preferably from 1 to 50 parts by weight, still more preferably from 1.0 to 10.0 parts by weight, per 100 parts by weight of the components of the photosensitive layer. On the other hand, when the polymerization initiator per se having an absorption in the visible region, for example, the titanocene compound, is used under a yellow lamp or white lamp, the amount of polymerization initiator used is preferably smaller in view of fogging due to light in the vicinity of 500 nm. However, when it is used in combination with a sensitizing dye optionally used in the invention, sufficiently high photosensitivity can be obtained even when the amount of polymerization initiator used is reduced to 6 parts by weight or less, further to 1.9 parts by weight or less, still further to 1.4 parts by weight or less, per 100 parts by weight of the components of the photosensitive layer.

### (iv) Sensitizing dye

In the photo-initiation system according to the invention, it is preferred to use a sensitizing dye for the purpose of increasing photosensitivity.

Preferred examples of the sensitizing dye are described below.

Preferred examples of the sensitizing dye for use in the invention include sensitizing dyes having an absorption wavelength in a range from 350 to 450 nm and belonging to the following compound groups: polynuclear aromatic compounds (for example, pyrene, perylene or triphenylene), xanthenes (for example, Fluoresceine, Eosine, Erythrocin, Rhodamine B or Rose Bengale), cyanines (for example, thiacarbocyanine or oxacarbocyanine), merocyanines (for example, merocyanine or carbomerocyanine), thiazines (for example, Thionine, Methylene Blue or Toluidine blue), acridines (for example, Acridine Orange, chloroflavine or acriflavine), anthraquinones (for example, anthraquinone), and squaliums (for example, squalium).

More preferable examples of the sensitizing dye include compounds represented by the following formulae (XIV) to (XVIII) :

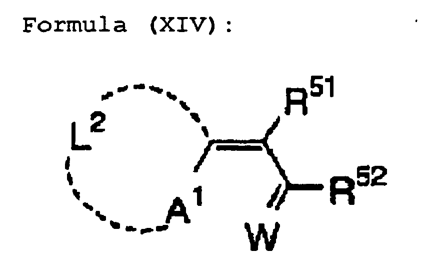

In formula (XIV), A¹ represents a sulfur atom or -N(R⁵⁰) -, R⁵⁰ represents an alkyl group or an aryl group, L² represents a non-metallic atomic group necessary for forming a basic nucleus of the dye together with the adjacent A¹ and the adjacent carbon atom, R⁵¹ and R⁵² each independently represents a hydrogen atom or a monovalent non-metallic atomic group, or R⁵¹ and R⁵² may be combined with each other to form an acidic nucleus of the dye, and W represents an oxygen atom or a sulfur atom.

Preferred specific examples of the compound represented by formula (XIV) are set forth below.

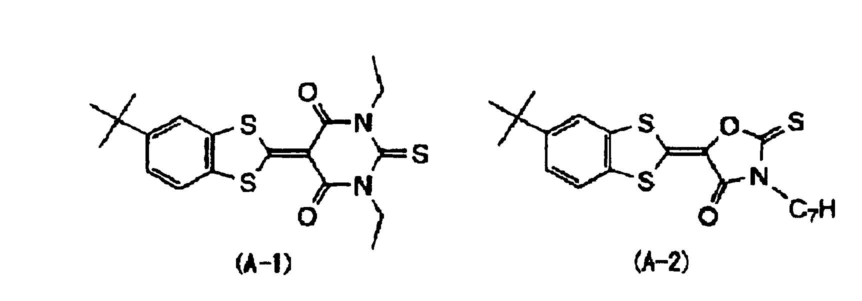

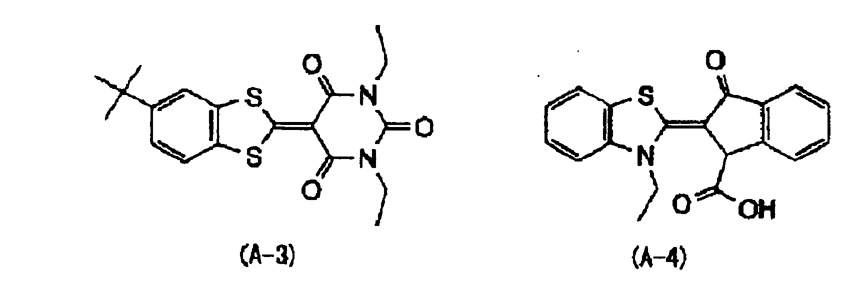

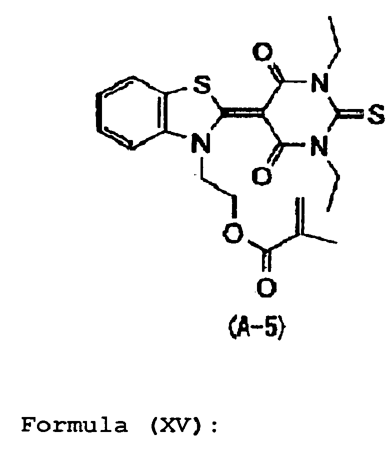

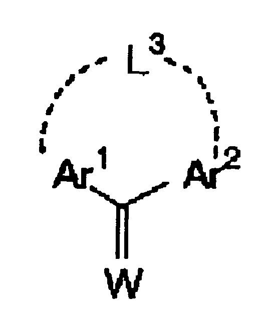

In formula (XV), Ar¹ and Ar² each independently represents an aryl group and are connected with each other through -L³-, L³ represents -O- or -S-, and W has the same meaning as W in formula (XIV).

Preferred specific examples of the compound represented by formula (XV) are set forth below.

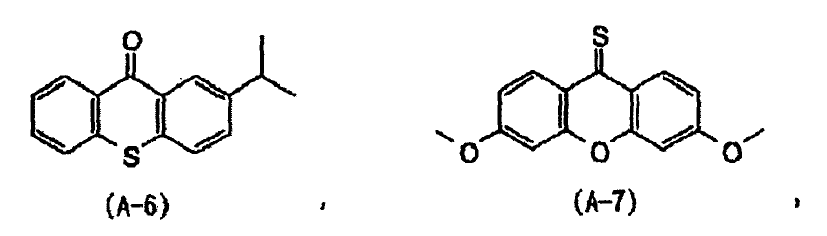

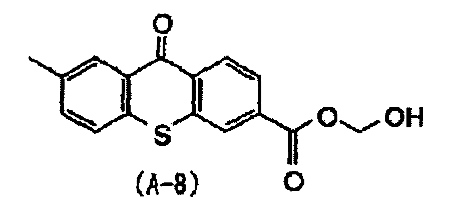

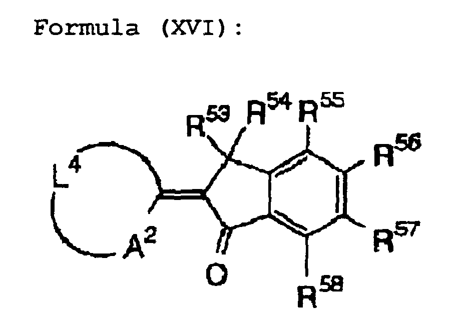

In formula (XVI), A² represents a sulfur atom or -N (R⁵⁹)-, L⁴ represents a non-metallic atomic group necessary for forming a basic nucleus of the dye together with the adjacent A² and the adjacent carbon atom, R⁵³, R⁵⁴, R⁵⁵, R⁵⁶, R⁵⁷ and R⁵⁸ each independently represents a hydrogen atom or a monovalent non-metallic atomic group, and R⁵⁹ represents an alkyl group or an aryl group.

Preferred specific examples of the compound represented by formula (XVI) are set forth below.

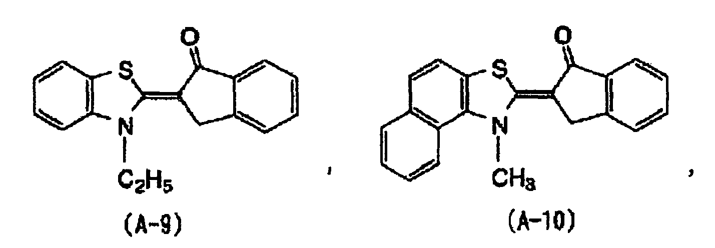

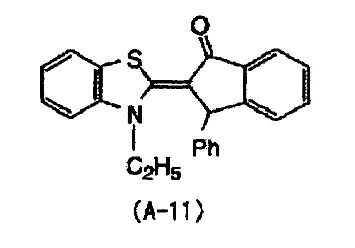

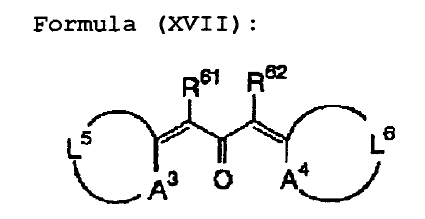

In formula (XVII), A³ and A⁴ each independently represents -S- or -N (R⁶⁰) - or -N(R⁶³)-, R⁶⁰ and R⁶³ each independently represents a substituted or unsubstituted alkyl group or a substituted or unsubstituted aryl group, L⁵ and L⁶ each independently represents a non-metallic atomic group necessary for forming a basic nucleus of the dye together with the adjacent A³ or A⁴ and the adjacent carbon atom, R⁶¹ and R⁶² each independently represents a hydrogen atom or a monovalent non-metallic atomic group or R⁶¹ and R⁶² may be combined with each other to form an aliphatic or aromatic ring.

Preferred specific examples of the compound represented by formula (XVII) are set forth below.

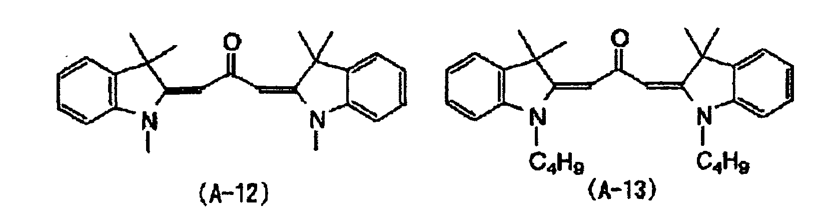

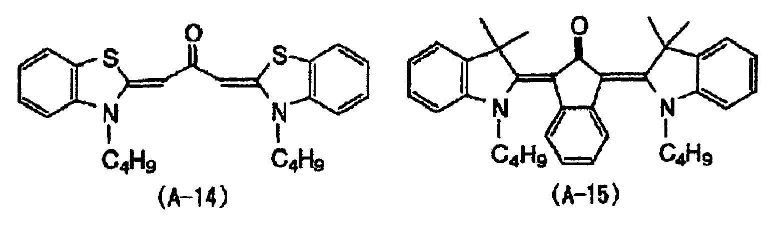

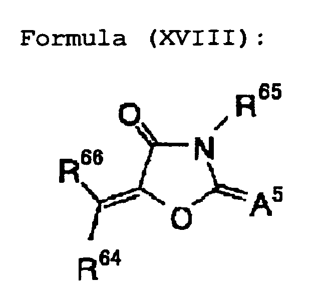

In formula (XVIII), R⁶⁶ represents an aromatic ring group which may have a substituent or a hetero ring group which may have a substituent, A⁵ represents an oxygen atom, a sulfur atom or =N-R⁶⁷, R⁶⁴, R⁶⁵ and R⁶⁷ each independently represents a hydrogen atom or a monovalent non-metallic atomic group, or R⁶⁷ and R⁶⁴ or R⁶⁵ and R⁶⁷ may be combined with each other to form an aliphatic or aromatic ring.

Preferred specific examples of the compound represented by formula (XVIII) are set forth below.

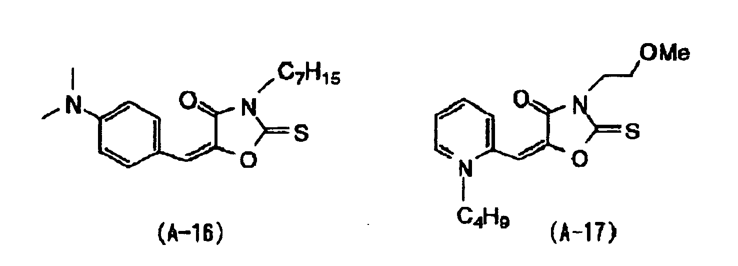

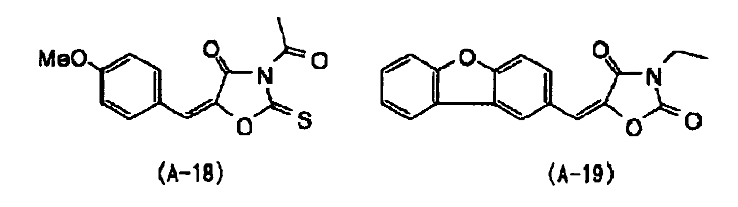

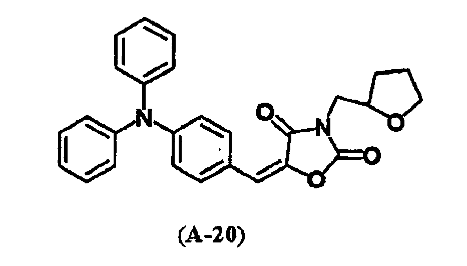

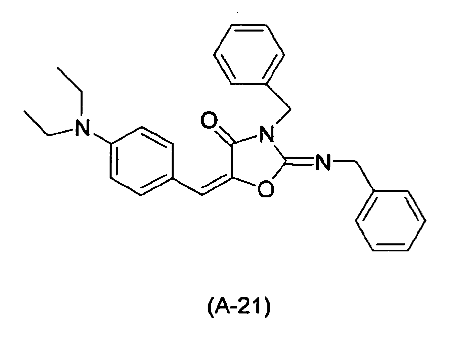

Of the sensitizing dyes, those represented by formulae (XVI) and (XVIII) are preferable, and those represented by formula (XVIII) are particularly preferable.

The sensitizing dye for use in the invention may be subjected to various chemical modifications in order to improve performances of the photosensitive layer used in a lithographic printing plate precursor. For instance, the sensitizing dye may be bound to an addition-polymerizable compound structure (for example, an acryloyl group or methacryloyl group) by a covalent bond, ionic bond, hydrogen bond or the like, whereby strength of the exposed layer can be increased and undesirable deposition of the dye in the layer after exposure can be inhibited.

Also, in case of using the photosensitive composition of the invention for the preparation of a photosensitive layer of a lithographic printing plate precursor, introduction of a hydrophilic site (an acidic group or a polar group, for example, a carboxyl group or an ester thereof, a sulfonic group or an ester thereof, or an ethylene oxide group) to the dye is effective for the purpose of enhancing the processing suitability with an (alkali) aqueous developer, which is a preferred use embodiment of the photosensitive layer. Particularly, the ester-type hydrophilic group has a feature in that it exhibits excellent compatibility in the photosensitive layer due to the relatively hydrophobic structure thereof and in the developer, it is hydrolyzed to generate an acid group, thereby increasing hydrophilicity. In addition, a substituent can be appropriately introduced, for example, for improving the compatibility or inhibiting the deposition of crystal in the photosensitive layer. For example, in a certain kind of photosensitive system, an unsaturated bond of an aryl group, an allyl group or the like is sometimes very effective for improving the compatibility. Further, the formation of a steric hindrance between π planes of the dyes by a method, for example, introduction of a branched alkyl structure can significantly inhibit the deposition of crystal. Also, adhesion to an inorganic material, for example, metal or metal oxide can be improved by the introduction of a phosphonic acid group, an epoxy group, a trialkoxysilyl group or the like. If desired, polymerization of the sensitizing dye may also be used.

Details of a use method of the sensitizing dye, for example, selection of the structure, sole or combination use and amount added can be appropriately determined in accordance with the designed performance of the final photosensitive material. For instance, when two or more sensitizing dyes are used in combination, the compatibility thereof with the photosensitive composition layer can be increased. For the selection of sensitizing dye, the molar absorption coefficient thereof at an emission wavelength of a light source used is an important factor in addition to the photosensitivity. Use of a dye having a large molar absorption coefficient is profitable, because the amount of dye added can be made relatively small. Also, in case of preparing a lithographic printing plate precursor, the use of such a dye is advantageous in view of physical properties of the photosensitive layer. Since the photosensitivity and resolution of the photosensitive layer and the physical properties of the exposed layer are greatly affected by the absorbance at the wavelength of light source, the amount of the sensitizing dye added is appropriately determined by taking account of these factors. For example, the sensitivity decreases in the low absorbance region of 0.1 or less. Also, the resolution decreases due to the influence of halation.

However, for the purpose of hardening a layer having a large thickness of 5 µm or more, such low absorbance is sometimes rather effective for increasing the hardening degree. On the other hand, in the high absorbance region of 3 or more, the light is mostly absorbed on the surface of the photosensitive layer so that hardening in a more inner part is inhibited and as a result, when, for example, a printing plate is manufactured, the layer strength and the adhesion to a substrate become insufficient. In the case of using as a lithographic printing plate precursor where the photosensitive layer has a relatively small thickness, the amount of the sensitizing dye added is preferably selected such that the photosensitive layer has an absorbance from 0.1 to 1.5, preferably from 0.25 to 1. In the case of using as the lithographic printing plate precursor, the amount of the sensitizing dye added is usually from 0.05 to 30 parts by weight, preferably from 0.1 to 20 parts by weight, and more preferably from 0.2 to 10 parts by weight, per 100 parts by weight of the photosensitive layer components.

### (v) Other components

The photosensitive composition of the invention may further appropriately contain other components suitable for the use or production method thereof or the like. Preferred additives are described below.

### (v-1) Co-sensitizer

The sensitivity can be further increased by using a certain additive (hereinafter referred to as a "co-sensitizer") . The mechanism thereof is not clearly known but considered to be mostly based on the following chemical process. Specifically, the co-sensitizer reacts with various intermediate active species (for example, a radical, peroxide, oxidizing agent or reducing agent) generated during the process of photo-reaction initiated upon light absorption of the above-described photo-initiation system and the subsequent addition-polymerization reaction, to produce new active radicals. Such compounds are roughly classified into (a) compound which is reduced to produce an active radical, (b) compound which is oxidized to produce an active radical and (c) compound which reacts with a radical having low activity to convert it into a more highly active radical or act as a chain transfer agent. However, in many cases, a common view is not present about which compound belongs to which type.

### (a) Compound which is reduced to produce an active radical Compound having a carbon-halogen bond:

It is believed that an active radical is generated by reductive cleavage of the carbon-halogen bond. Specific examples of the compound which can be preferably used include trihalomethyl-s-triazines and trihalomethyloxadiazoles.

### Compound having a nitrogen-nitrogen bond:

It is believed that an active radical is generated by reductive cleavage of the nitrogen-nitrogen bond. Specific examples of the compound which can be preferably used include hexaarylbiimidazoles.

### Compound having an oxygen-oxygen bond:

It is believed that an active radical is generated by reductive cleavage of the oxygen-oxygen bond. Specific examples of the compound which can be preferably used include organic peroxides.

### Onium compound:

It is believed that an active radical is generated by reductive cleavage of the carbon-hetero bond or oxygen-nitrogen bond. Specific examples of the compound which can be preferably used include diaryliodonium salts, triarylsulfonium salts and N-alkoxypyridinium (azinium) salts.

### Ferrocene and iron allene complexes:

An active radical may be reductively produced.

### (b) Compound which is oxidized to produce an active radical Alkylate complex:

It is believed that an active radical is generated by oxidative cleavage of the carbon-hetero bond. Specific examples of the compound which can be preferably used include triaryl alkylborates.

### Alkylamine compound:

It is believed that an active radical is generated by oxidative cleavage of the C-X bond on the carbon adjacent to the nitrogen, where X is preferably, for example, a hydrogen atom, a carboxyl group, a trimethylsilyl group or a benzyl group. Specific examples of the compound include ethanolamines, N-phenylglycines and N-trimethylsilylmethylanilines.

### Sulfur-containing or tin-containing compound:

Compounds in which the nitrogen atom of the above-described amines is replaced by a sulfur atom or a tin atom are produced an active radical in the same function as above. Also, a compound having an S-S bond is known to effect sensitization by the cleavage of S-S.

### α-Substituted methylcarbonyl compound:

An active radical is produced by oxidative cleavage of the carbonyl-α carbon bond. A compound in which the carbonyl is converted into an oxime ether also shows the similar function. Specific examples of the compound include 2-alkyl-1-[4-(alkylthio)phenyl]-2-morpholinopronone-1 and oxime ethers thereof obtained by a reaction with a hydroxyamine and subsequent etherification of the N-OH.

### Sulfinic acid salt:

An active radical may be reductively produced. Specific examples of the compound include sodium arylsulfinate.

### (c) Compound which reacts with a radical to convert it into a more highly active radical or acts as a chain transfer agent:

For example, compounds having SH, PH, SiH or GeH in their molecules are used. These compounds donate hydrogen to a low activity radical species to produce a radical or are oxidized and deprotonized to produce a radical. Specific examples of the compound include 2-mercaptobenzimidazoles.

A large number of examples of the co-sensitizer are more specifically described, for example, in JP-A-9-236913 as an additive for improving sensitivity. Some of these are set forth below, but the invention should not be construed as being limited thereto. In the following formulae, -TMS represents a trimethylsilyl group.

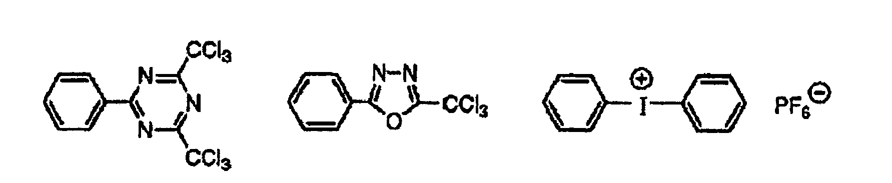

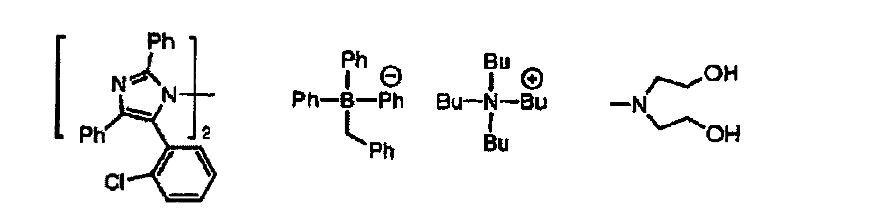

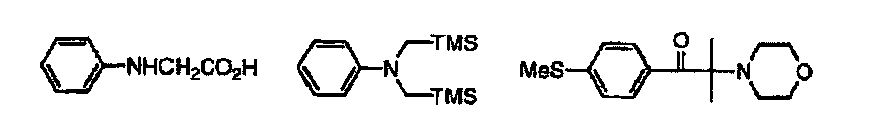

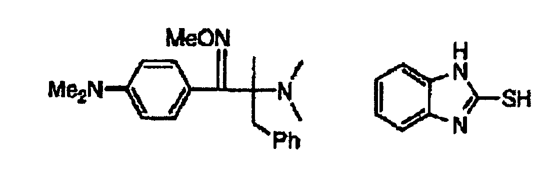

Similarly to the above-described sensitizing dye, the co-sensitizer can be subjected to various chemical modifications in order to improve the characteristics of the photosensitive layer. For instance, methods of binding to the sensitizing dye, activator, addition-polymerizable unsaturated compound or other parts, introduction of a hydrophilic site, introduction of a substituent for improving compatibility or inhibiting deposition of crystal, introduction of a substituent for improving adhesion, or formation of a polymer may be used.

The co-sensitizers can be used individually or in combination of two or more thereof. The amount of the co-sensitizer used is from 0.05 to 100 parts by weight, preferably from 1 to 80 parts by weight, more preferably from 3 to 50 parts by weight, per 100 parts by weight of the compound having an ethylenically unsaturated double bond.

### (v-2) Polymerization inhibitor

In the invention, it is desirable to added a small amount of a thermal polymerization inhibitor to the photosensitive composition in addition to the above-described basic components in order to prevent the polymerizable compound having an ethylenically unsaturated double bond from undergoing undesirable thermal polymerization during the production or storage of the photosensitive composition. Examples of suitable thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol) and N-nitrosophenylhydroxyamine cerium(III) salt. The amount of the thermal polymerization inhibitor added is preferably from about 0.01 to about 5% by weight, based on the weight of the total photosensitive composition. If desired, in order to prevent polymerization inhibition due to oxygen, a higher fatty acid derivative, for example, behenic acid or behenic acid amide may be added and allowed to localize on the surface of photosensitive layer during a drying step after the coating on a support. The amount of the higher fatty acid derivative added is preferably from about 0.5 to about 10% by weight based on the total photosensitive composition.

### (v-3) Coloring agent or the like

In case of using the photosensitive composition of the invention for a photosensitive layer of a lithographic printing plate precursor, a dye or a pigment may be added for the purpose of coloring the photosensitive layer. By such a coloring, so-called plate inspection, for example, visibility of a printing plate after the plate-making or suitability for an image density measuring device can be improved. Since many dyes cause reduction in the sensitivity of photopolymerizable photosensitive layer, a pigment is preferably used as the coloring agent. Specific examples of the coloring agent include pigments, for example, phthalocyanine-base pigment, azo-base pigment, carbon black and titanium oxide, and dyes, for example, Ethyl Violet, Crystal Violet, azo-base dye, anthraquinone-base dye and cyanine-base dye. The amount of the dye or pigment added is preferably from about 0.5 to about 5% by weight based on the total photosensitive composition.

### (v-4) Other additives

Other known additives may further be added, for example, inorganic filler or a plasticizer for improving physical properties of the hardened layer or an oil-sensitizer capable of improving the ink-receptive property on the surface of photosensitive layer.

Examples of the plasticizer include dioctyl phthalate, didodecyl phthalate, triethylene glycol dicaprylate, dimethyl glycol phthalate, tricresyl phosphate, dioctyl adipate, dibutyl sebacate and triacetylglycerol. In the case of using a binder, the plasticizer can be added in an amount of 10% by weight or less based on the total weight of the polymerizable compound having an unsaturated double bond and the binder.

Also, an UV initiator, a heat crosslinking agent or the like may be added for increasing the effect of heating or light exposure conducted after the development in order to improve the layer strength (printing durability) as described hereinafter.

In addition, for improving the adhesion between the photosensitive layer and a support or increasing the developing and removing property of the unexposed photosensitive layer, an additive may be added or an interlayer may be provided. For instance, a compound exhibiting a relatively strong interaction with the support, for example, a compound having a diazonium structure or a phosphone compound may be added to the photosensitive layer or provided as an undercoat, whereby the adhesion is improved and the printing durability can be enhanced. Also, by the addition or undercoating of a hydrophilic polymer, for example, polyacrylic acid or polysulfonic acid, developing property of the non-image area is improved and resistance to stain can be increased.

In the case of coating the photosensitive composition of the invention on a support to provide a lithographic printing plate precursor, the photosensitive composition can be used after dissolving it in various organic solvents. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate and ethyl lactate. The solvents may be used individually or as a mixture thereof. The concentration of solid content in the coating solution is appropriately from 2 to 50% by weight.

Since the coverage of the photosensitive layer on the support may affect mainly the sensitivity and developing property of the photosensitive layer, the strength of the exposed layer and the printing durability, it is preferably determined according to the use. When the coverage is too small, the printing durability becomes not sufficient. On the other hand, when it is excessively large, the sensitivity decreases, as a result, not only the exposure but also the development processing disadvantageously take a longer time. In the case of a lithographic printing plate precursor for scanning exposure, which is a main object of the invention, the coverage of the photosensitive layer is preferably from about 0.1 to about 10 g/m², more preferably from 0.5 to 5 g/m², and still more preferably from 0.8 to 2.0 g/m², in terms of weight after drying.

### [Overcoat Layer]

On the photosensitive layer described above, an oxygen blocking protective layer (overcoat layer) is ordinarily provided in order to avoid polymerization inhibiting function of oxygen. The coating amount of the oxygen blocking protective layer according to the invention is preferably in a range of 0.7 to 3.0 g/m².

The oxygen blocking protective layer contains a water-soluble vinyl polymer. Examples of the water-soluble vinyl polymer include polyvinyl alcohol, a partial ester, ether or acetal thereof and a copolymer thereof containing a substantial amount of an unsubstituted vinyl alcohol unit necessary for providing the water-solubility. Examples of the polyvinyl alcohol include those which are hydrolyzed to an extent of 71 to 100% and which have a polymerization degree in a range of 300 to 2,400. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, all of which are produced by Kuraray Co., Ltd., are enumerated.

The copolymer includes polyvinyl acetate chloroacetate or propionate, polyvinyl formal and polyvinyl acetal each hydrolyzed to an extent of 88 to 100% and copolymers thereof. Other useful polymers include, for example, polyvinyl pyrrolidone, gelatin and gum arabic. The polymers may be used individually or in combination.

As a solvent used for coating the oxygen blocking protective layer in the lithographic printing plate precursor according to the invention, although pure water is preferable, a mixture of pure water with an alcohol, for example, methanol or ethanol or a ketone, for example, acetone or methyl ethyl ketone may be used. The concentration of the solid content in the coating solution is appropriately from 1 to 20% by weight. To the oxygen blocking protective layer according to the invention may be added known additives, for example, a surfactant for improving coating property or a water-soluble plasticizer for improving physical property of the coated layer. Examples of the water-soluble plasticizer include propionamide, cyclohexanediol, glycerin and sorbitol. Also, a water-soluble (meth) acrylic polymer may be added. The coverage of the oxygen blocking protective layer is preferably from about 0.1 to about 15 g/m², more preferably from 1.0 to about 5 g/m², in terms of weight after drying.

### [Plate-Making Process]

Now, a plate-making method for the lithographic printing plate precursor of the invention is described in detail below. As for the exposure method of the lithographic printing plate precursor, an AlGaInN semiconductor laser (commercially available InGaN semiconductor laser: 5 to 30 mW) is preferably used as a light source in view of wavelength characteristics and cost.

The exposure mechanism may be any of internal drum system, external drum system and flat bed system. When the photosensitive layer component of the lithographic printing plate precursor according to the invention used has high water solubility, the photosensitive layer can be made soluble in neutral water or alkalescent water, and the lithographic printing plate precursor having such a construction can be loaded on a printing machine and then subjected to exposure and development on the machine. After the imagewise exposure, the entire surface of the lithographic printing plate precursor may be heated, if desired, between the exposure and development. By means of the heating, the image forming reaction in the photosensitive layer is accelerated and advantages, for example, improvement in the sensitivity and printing durability and stabilization of the sensitivity are achieved. For the purpose of improving the image strength and printing durability, it is also effective to perform entire after-heating or entire exposure of the image after development. Ordinarily, the heating before development is preferably performed under a mild condition of 150°C or lower. The heating after development uses a very strong condition, and it is ordinarily conducted in a temperature rage of 200 to 500°C.

### (Developer)

The developer for use in the plate-making method of the lithographic printing plate precursor is not particularly restricted. However, for example, a solution containing an inorganic alkali salt and a surfactant and having a pH of 13 or less is preferably used. More preferably, the pH of the developer is from 10.0 to 12.5

The inorganic alkali salt can be appropriately used. Examples thereof include an inorganic alkali agent, for example, sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. The inorganic alkali salts may be used individually or in combination of two or more thereof.

In the case of using the silicate, the developing property can be easily adjusted by selecting a mixing ratio of silicon oxide (SiO₂) to alkali oxide (M₂O (wherein M represents an alkali metal or an ammonium group)), which are the components of the silicate, and the concentration thereof. Of the aqueous alkali solutions, an aqueous alkali solution having the mixing ratio of silicon oxide (SiO₂) to alkali oxide (M₂O) (SiO₂/M₂O in molar ratio) of 0.5 to 3.0 is preferred, and that of 1.0 to 2.0 is more preferred. The amount of the SiO₂/M₂O added is preferably from 1 to 10% by weight, more preferably from 3 to 8% by weight, and most preferably from 4 to 7% by weight, based on the weight of the aqueous alkali solution. When the amount is 1% by weight or more, the developing property and processing ability are not deteriorated whereas, when it is 10% by weight or less, the formation of precipitates and crystals are inhibited and gelation at neutralization of waste liquor of the developer is prevented, thereby causing no troubles in treatment of the waste liquor.

Also, an organic alkali agent may be supplementarily used for the purposes of delicate adjustment of alkali concentration and of assisting dissolution of the photosensitive layer. Examples of the organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The organic alkali agents may be used individually or in combination of two or more thereof.

The surfactant is appropriately used. Examples thereof include nonionic surfactants, for example, a nonionic surfactant having polyoxyalkylene ether group, a polyoxyethylene alkyl ester (e.g., polyoxyethylene stearate), a sorbitan alkyl ester (e.g., sorbitan monolaurate, sorbitan monostearate, sorbitan distearate, sorbitan monooleate, sorbitan sesquioleate or sorbitan trioleate) and a monoglyceride alkyl ester (e.g., glycerol monostearate or glycerol monooleate); anionic surfactants, for example, an alkylbenzenesulfonate (e.g., sodium dodecylbenzenesulfonate), an alkylnaphthalenesulfonate (e.g., sodium butylnaphthalenesulfonate, sodium pentylnaphthalenesulfonate, sodium hexylnaphthalenesulfonate or sodium octylnaphthalenesulfonate), an alkylsulfate (e.g., sodium laurylsulfate), an alkylsulfonate (e.g., sodium dodecylsulfonate) and a sulfosuccinic acid ester salt (e.g., sodium dilaurylsulfosuccinate); and amphoteric surfactants, for example, an alkylbetaine (e.g., laurylbetaine or stearylbetaine) and an amino acid. Nonionic surfactants having a polyoxyalkylene ether group are particularly preferred.

As the surfactant having a polyoxyalkylene ether group, compounds having the structure represented by formula (a) shown below are preferably used.

R₄₀-O- (R₄₁-O)ₚH (a)

In the formula, R₄₀ represents an alkyl group having from 3 to 15 carbon atoms which may have a substituent, an aromatic hydrocarbon group having from 6 to 15 carbon atoms which may have a substituent or a heteroaromatic ring group having from 4 to 15 carbon atoms which may have a substituent. Examples of the substituent include an alkyl group having from 1 to 20 carbon atoms, a halogen atom, e.g., Br, Cl or I, an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms and an acyl group having from 2 to 15 carbon atoms. R₄₁ represents an alkylene group having from 1 to 100 carbon atoms which may have a substituent. Examples of the substituent include an alkyl group having from 1 to 20 carbon atoms and an aromatic hydrocarbon group having from 6 to 15 carbon atoms. p represents an integer of 1 to 100.

In the definition of formula (a), specific examples of the "aromatic hydrocarbon group" include a phenyl group, a tolyl group, a naphthyl group, an anthryl group, a biphenyl group and a phenanthryl group, and specific examples of the "heteroaromatic ring group" include a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group and a benzimidazolyl group.

Also, the moiety of (R₄₁-O)ₚ in formula (a) may comprise two or three kinds of groups to the extent that the above-described definitions are fulfilled. Specifically, there may be illustrated a random or block chain of a combination of ethyleneoxy group and propyleneoxy group, a combination of ethyleneoxy group and isopropyleneoxy group, a combination of ethyleneoxy group and butyleneoxy group, and a combination of ethyleneoxy group and isobutyleneoxy group. In the invention, the surfactants having polyoxyalkylene ether group are used individually or in combination thereof. The surfactant is preferably added in an amount from 1 to 30% by weight, more preferably from 2 to 20% by weight, to the developer. The amount described above is effective for the developing property and the printing durability of a printing plate.

Examples of the nonionic surfactant having polyoxyalkylene ether group represented by formula (a) include a polyoxyethylene alkyl ether, e.g., polyoxyethylene lauryl ether, polyoxyethylene cetyl ether or polyoxyethylene stearyl ether; a polyoxyethylene aryl ether, e.g., polyoxyethylene phenyl ether or polyoxyethylene naphthyl ether; and a polyoxyethylene alkylaryl ether, e.g., polyoxyethylene methylphenyl ether, polyoxyethylene octylphenyl ether or polyoxyethylene nonylphenyl ether.

The surfactants can be used individually or in combination thereof. Also, the amount of the surfactant used in the developer is preferably in a range of 0.1 to 20% by weight in terms of the solid content.

The electric conductivity of the developer used in the invention is preferably from 3 to 30 mS/cm. When the electric conductivity is 3 mS/cm or more, dissolution of the photopolymerizable photosensitive layer on the aluminum support surface can be surely conducted to prevent the occurrence of stain at printing, whereas when it is 30 mS/cm or less, since the salt concentration is not too high, a dissolution rate of the photopolymerizable photosensitive layer does not become extremely low, thereby preventing the occurrence of remaining layer in the unexposed area. The electric conductivity is particularly preferably in a range of 5 to 20 mS/cm.

The development of the lithographic printing plate precursor according to the invention is conducted at a temperature from 0 to 60°C, preferably from about 15 to about 40°C, in a conventional manner, for example, by immersing the exposed lithographic printing plate precursor in the developer and rubbing it with a brush.

Further, in the case of conducting the development processing using an automatic developing machine, since the developer becomes fatigued in accordance with the amount of processing, the processing ability may be restored by using a replenisher or a fresh developer.

The thus development-processed lithographic printing plate precursor is subjected to after-treatment with washing water, a rinse solution containing, for example, a surfactant, or a desensitizing solution containing, for example, gum arabic or a starch derivative, as described, for example, in JP-A-54-8002, JP-A-55-115045 and JP-A-59-58431. In the after-treatment of the lithographic printing plate precursor according to the invention, these treatments may be used in combination.

The printing plate thus-obtained in accordance with the above-described processing can be improved in the printing durability thereof by conducting an after-exposure treatment according to the method described in JP-A-2000-89478 or a heating treatment, for example, baking.

The lithographic printing plate thus-obtained is mounted on an offset printing machine to use for printing a large number of sheets.

### EXAMPLES

The present invention will be described in more detail with reference to the following examples, but the invention should not be construed as being limited thereto.

### EXAMPLES 1 TO 15

### [Support]

### (Support 1: Anodized Aluminum Support)

A 0.30-mm thick aluminum plate of 1S material was grained at the surface thereof using a No.8 nylon brush and an aqueous suspension containing 800-mesh pumice stone, and then thoroughly washed with water. The plate was immersed in a 10% sodium hydroxide aqueous solution at 70°C for 60 seconds to etch, followed by washing with running water, neutralizing with 20% HNO₃ aqueous solution, and then washing with water. The plate was then subjected to the electrolytic surface roughening treatment in a 1% nitric acid aqueous solution under the condition of VA=12.7 V at an anodic time electricity of 300 Coulomb/dm² using a current having an alternating sine wave form. The surface roughness was measured and found to be 0.45 µm (in terms of Ra). Subsequently, the plate was immersed in a 30% H₂SO₄ aqueous solution to desmut at 55°C for 2 minutes. Then, the plate was anodized in a 20% H₂SO₄ aqueous solution of 33°C at an electric current of 5 A/dm² for 50 seconds with disposing a cathode to the grained surface to form an anodic oxide film of 2.6 g/m² in thickness. The resulting plate was referred to as Support 1.

### (Support 2)

A subbing solution shown below was coated on Support 1 using a bar coater so as to have a dry coating amount of 2 mg/m², followed by drying at 80°C for 20 seconds to prepare Support 2.

### <Subbing Solution>

| | |
|---|---|
| Polymer (P1) shown below | 0.3 g |
| Pure water | 60.0 g |
| Methanol | 939.7 g |

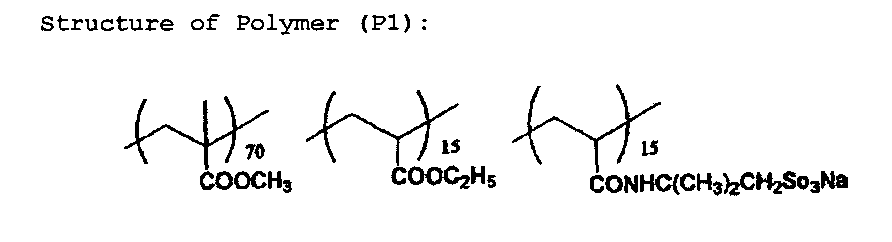

On Support 2 was coated a photosensitive composition shown below (15 kinds in total each corresponding to Examples 1 to 15) using a bar coater, followed by drying at 100°C for one minute. The weight of photosensitive composition after drying was 1.3 g/m².

### <Photosensitive Composition>

| | |
|---|---|
| Ethylenically unsaturated | 1.1 parts by weight |
| bond-containing compound (A-1) Binder polymer | 1.0 part by weight |
| (Compound P-1, P-2, P-4, P-6, P-7, P-8, P-10, P-12, P-13, P-17, P-19 or P-20 shown in Table 1 below) | |
| Sensitizing dye (D-1) | 0.15 parts by weight |
| Polymerization initiator | 0.12 parts by weight |
| (Compound C-1 or C-2 shown in Table 1 below) | |
| ε-Phthalocyanine (F-1) dispersion | 0.02 parts by weight |
| Sensitizing aid | 0.5 parts by weight |
| (Compound G-1 or G-2 shown in Table 1 below) | |
| Fluorine-based nonionic surfactant | 0.02 parts by weight |
| (Megafac F-780F, produced by Dainippon Ink & Chemicals, Inc.) | |
| Methyl ethyl ketone | 26.0 parts by weight |
| Propylene glycol monomethyl ether | 26.3 parts by weight |

On the photosensitive layer was coated an aqueous solution for protective layer shown below using a bar coater so as to have a dry coating amount of 2.5 g/m², followed by drying at 120°C for one minute. Thus, Lithographic Printing Plate Precursors 1 to 15 (corresponding to Examples 1 to 15) were prepared.

### <Aqueous Solution for Protective Layer>

| | |
|---|---|
| Polyvinyl alcohol | 5.0 parts by weight |
| (saponification degree: 98% by mole; polymerization degree: 500) | |
| Nonionic surfactant | 0.09 parts by weight |
| (EMALEX 710, produced by Nihon-Emulsion Co., Ltd.) | |
| Pure water | 94.91 parts by weight |

### (Evaluation of Uniformity of Halftone Dot)

The lithographic printing plate precursor was loaded in a violet semiconductor laser setter Vx9600 (InGaN semiconductor laser: 405 nm ± 10 nm emission/output: 30 mW, produced by FUJIFILM Electronic Imaging, Ltd.), and thereon were drawn halftone dots of 35% using an FM screen (TAFFETA 20, produced by Fuji Photo Film Co., Ltd.) in an exposure amount of 90 µJ/cm² and resolution of 2,438 dpi. The exposed lithographic printing plate precursor was automatically conveyed to a connecting automatic developing machine (LP1250PLX) (equipped with brushes), and it was heated at 100°C for 10 seconds, washed with water to remove the PVA protective layer and then subjected to development processing at 28°C for 20 seconds. The developer used was a solution prepared by diluting Developer DV-2 (produced by Fuji Photo Film Co., Ltd.) five times with water. The developed plate was washed with a rinse bath and conveyed to a gum coating bath containing a solution prepared by diluting Gum Solution FP-2W (produced by Fuji Photo Film Co. , Ltd.) twice with water. After the gum coating, the plate was dried with hot air and discharged to obtain a lithographic printing plate having the halftone dots drawn. An area ratio of the halftone dot of the lithographic printing plate was measured using CC-dot and an area difference (δ dot 1) between the maximum value and the minimum value was determined. As the uniformity of halftone dot is higher, the value of δ dot 1 becomes smaller. The results are shown in Table 1 below.

### (Evaluation of pH Dependency of Developer)

The lithographic printing plate precursor was subjected to the exposure in the same manner as in the evaluation of uniformity of halftone dot described above. Then, the exposed lithographic printing plate precursor was subjected to the development processing by the automatic developing machine in the same manner as in the evaluation of uniformity of halftone dot except that a developer prepared by diluting Developer DV-2 (produced by Fuji Photo Film Co., Ltd.) with water to adjust pH to 11.70 or 12.20 was used as the developer. The developed plate was washed with a rinse bath and conveyed to a gum coating bath containing a solution prepared by diluting Gum Solution FP-2W (produced by Fuji Photo Film Co., Ltd.) twice with water. After the gum coating, the plate was dried with hot air and discharged to obtain a lithographic printing plate having the halftone dots drawn. An area ratio of the halftone dot of the lithographic printing plate was measured using CC-dot and an area difference (δ dot 2) between the case of development with the developer having pH of 11.70 and the case of development with the developer having pH of 12.20 was determined. The results are shown in Table 1 below.

### (Evaluation of Sensitivity)

The lithographic printing plate precursor was subjected to the exposure and development processing in the same manner as in the evaluation of unevenness of halftone dot described above to form an image. An average halftone dot area % from halftone dot of 20% input to halftone dot of 50% input was measured by a halftone dot measuring device (Gretag-Macbeth) . As the value of average halftone dot area % is larger, the sensitivity is higher. The results are shown in Table 1 below.

### COMPARATIVE EXAMPLES 1 TO 3

Photosensitive compositions for Comparative Examples 1 to 3 were prepared in the same manner as in the photosensitive composition of Example 1 except for not using binder polymer, using 1.0 part by weight of PC-1 and using 1.0 part by weight of PC-2 as shown in Table 1 below, respectively. Using each of the photosensitive composition as a photosensitive layer, a lithographic printing plate precursor was prepared and the evaluations thereof were conducted in the same manner as in Example 1. The results are shown in Table 1 below.

**TABLE 1**

| No. | Polymerization Initiator | Sensitizing Aid | Binder Polymer | | δ dot 1 | δ dot 2 | Sensitivity (20% - 50% halftone dot average value) |
|---|---|---|---|---|---|---|---|
| | | | Compound | Composition (molar ratio) Weight Average Molecular Weight | | | |
| Example 1 | C-1 | G-1 | P-1 | x/y/z/w=76/14/10/0 Mw=100,000 | 2.0 % | 2.0 % | 41 |
| Example 2 | C-1 | G-1 | P-2 | x/y/z/w=72/14/14/0 Mw=97,000 | 2.0 % | 2.5 % | 38 |
| Example 3 | C-1 | G-1 | P-6 | x/y/z/w=73/9/18/0 Mw=120,000 | 2.5 % | 2.5 % | 37 |
| Example 4 | C-1 | G-1 | P-4 | x/y/z/w=77/9/14/0 Mw=87,000 | 3.0 % | 2.5 % | 37 |
| Example 5 | C-1 | G-1 | P-8 | x/y/z/w=75/14/11/0 Mw=65,000 | 3.0 % | 2.5 % | 37 |
| Example 6 | C-1 | G-1 | P-10 | x/y/z/w=72/14/14/0 Mw=110,000 | 2.0 % | 2.0 % | 38 |
| Example 7 | C-1 | G-1 | p-12 | x/y/z/w=76/14/10/0 Mw=99,000 | 2.5 % | 3.0 % | 38 |
| Example 8 | C-1 | G-1 | P-13 | x/y/z/w=25/15/10/50 Mw=154,000 | 2.0 % | 3.0 % | 40 |
| Example 9 | C-1 | G-1 | P-17 | x/y/z/w=26/16/12/46 Mw=105,000 | 2.0 % | 2.0 % | 38 |
| Example 10 | C-1 | G-1 | P-1 | x/y/z/w=72/14/14/0 Mw=89,000 | 2.0 % | 2.0 % | 40 |
| Example 11 | C-1 | G-1 | P-19 | x/y/z/w=50/14/14/22 Mw=77,000 | 2.5 % | 2.0 % | 37 |
| Example 12 | C-1 | G-1 | P-20 | x/y/z/w=45/14/10/31 Mw=89,000 | 2.5 % | 2.0 % | 38 |
| Example 13 | C-2 | G-2 | P-1 | x/y/z/w=73/9/18/0 Mw=110,000 | 2.0 % | 2.5 % | 41 |
| Example 14 | C-2 | G-2 | P-7 | x/y/z/w=73/9/18/0 Mw=132,000 | 2.5 % | 2.5 % | 38 |
| Example 15 | C-2 | G-2 | P-19 | x/y/z/w=55/14/10/21 Mw=156,000 | 2.5 % | 2.5 % | 38 |
| Comparative Example 1 | C-1 | G-1 | none | - | no image formed | no image formed | no image formed |
| Comparative Example 2 | C-1 | G-1 | PC-1 | x/y/z/w=76/14/10/0 Mw=100,000 | 8.5 % | 2.0 % | 37 |
| Comparative Example 3 | C-1 | G-1 | PC-2 | x/y/z/w=76/14/10/0 Mw=121,000 | 2.0 % | 5.0 % | 40 |

Structures of Ethylenically unsaturated bond-containing compound (A-1), Sensitizing dye (D-1), Binder polymers (PC-1) and (PC-2), Polymerization initiators (C-1) and (C-2), ε-Phthalocyanine (F-1), and Sensitizing aids (G-1) and (G-2) are shown below. Binder polymers P-1, P-2, P-4, P-6, P-7, P-8 , P-10, P-12, P-13, P-17, P-19 and P-20 are those shown hereinbefore as the specific examples of the polymer according to the invention.

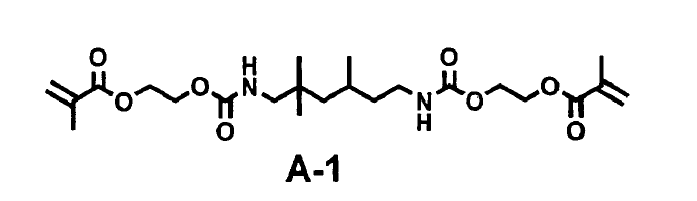

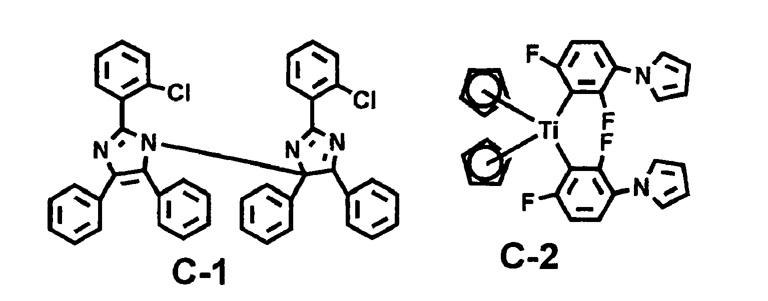

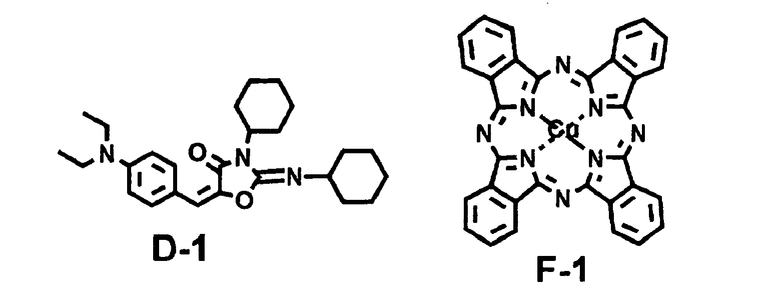

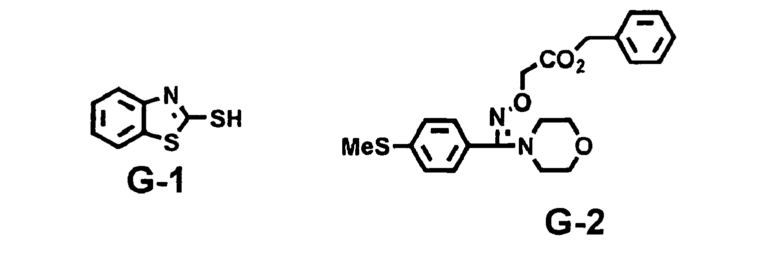

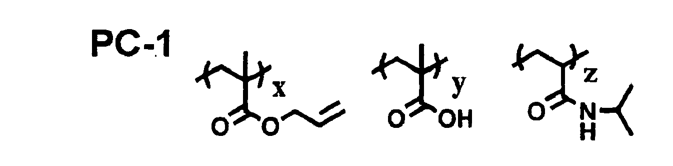

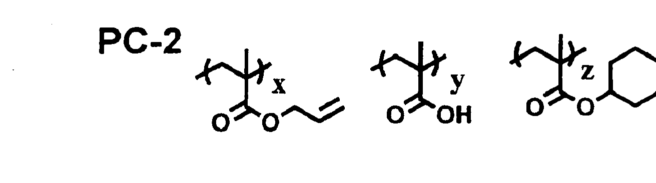

From the results shown in Table 1, it can be seen that the lithographic printing plates obtained in the examples are excellent in the uniformity of halftone dot and have less pH dependency of a developer. From the comparison of Examples 1 to 15 with Comparative Examples 2 and 3, it is also apparent that the use of the binder polymer having the specific structure according to the invention is effective in view of the improvement in the uniformity of halftone dot and the reduction of the pH dependency of a developer.

This application is based on Japanese Patent application JP 2005-79646, filed March 18, 2005, the entire content of which is hereby incorporated by reference, the same as if set forth at length.

## Claims

1. A photosensitive composition comprising:
(i) a polymer obtained by polymerization of a monomer having a structure represented by the following formula (I): 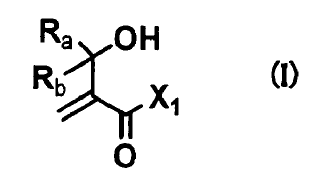 wherein X₁ represents -OR₁ or -N(R₂)(R₃), Rₐ and R_{b} each independently represents a hydrogen atom, a halogen atom, a cyano group or an organic group, and R₁, R₂ and R₃ each independently represents an alkyl group which may have a substituent, or Rₐ and R_{b} or X₁ and Rₐ or R_{b} may be connected with each other to form a cyclic structure;
(ii) a polymerizable compound having an unsaturated double bond; and
(iii) a radical polymerization initiator selected from a hexaarylbiimidazole compound and a metallocene compound.

2. The photosensitive composition as claimed in claim 1, wherein the polymer (i) has a structure unit represented by the following formula (II) or (III): 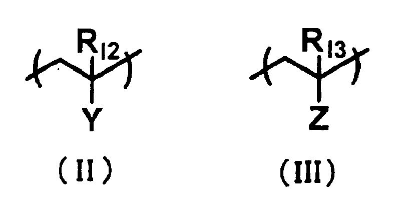 wherein R₁₂ and R₁₃ each independently represents a hydrogen atom or an alkyl group having from 1 to 6 carbon atoms, Y represents a functional group selected from -COOH, -CO-W₁-L₁-COOH and -SO₃H in which W₁ represents an oxygen atom, a sulfur atom or -NH-, L₁ represents a divalent organic group, Z represents -CO-O-CH₂-CH=CH₂ or -CO-W₂-L₂-O-CO-CR₁₄=CH₂, W₂ represents an oxygen atom, a sulfur atom or -NH-, L₂ represents a divalent organic group, and R₁₄ represents a hydrogen atom or an alkyl group having from 1 to 6 carbon atoms.

3. The photosensitive composition as claimed in claim 1, wherein the polymerizable compound (ii) has at least one ethylenically unsaturated double bond group.

4. The photosensitive composition as claimed in claim 1, wherein the polymerizable compound (ii) has at least two ethylenically unsaturated double bond groups.

5. The photosensitive composition as claimed in claim 1, wherein the radical polymerization initiator (iii) is a hexaarylbiimidazole compound.

6. The photosensitive composition as claimed in claim 5, wherein the hexaarylbiimidazole compound has chlorine atoms at o-position of aromatic rings of 2 and 2' positions thereof.

7. The photosensitive composition as claimed in claim 1, further comprising a sensitizing dye.

8. A lithographic printing plate precursor comprising a photosensitive layer containing the photosensitive composition as claimed in claim 1.
